# EUROPEAN PATENT APPLICATION

(11) **EP 4 300 730 A1**
(43) Date of publication of application: **03.01.2024**
(21) Application number: 22759578.2
(22) Date of filing: 21.02.2022
(51) Int. Cl.: H01S 5/028, H01S 5/02315

(54) **SEMICONDUCTOR DEVICE MANUFACTURING METHOD, SEMICONDUCTOR DEVICE, AND SEMICONDUCTOR APPARATUS**

(30) Priority: 26.02.2021 JP 2021030864
(71) Applicant: Kyocera Corporation, Kyoto-shi Kyoto 612-8501 (JP)
(72) Inventor: KAWAGUCHI, Yoshinobu, Kyoto-shi, Kyoto 612-8501 (JP); KAMIKAWA, Takeshi, Kyoto-shi, Kyoto 612-8501 (JP); MURAKAWA, Kentaro, Kyoto-shi, Kyoto 612-8501 (JP)
(74) Representative: Viering, Jentschura & Partner mbB Patent- und Rechtsanwälte
(86) International application number: PCT/JP2022/006935
(87) International publication number: WO 2022/181542

(57) **Abstract**

A manufacturing method for a semiconductor device according to the present disclosure includes preparing a laminate body 10 including a plurality of semiconductor layers 11, 12, and 13, and a first support body 20 including an upper surface 20a, a side surface 20b, and a recessed portion 21 including an opening adjacent to the upper surface 20a and the side surface 20b, bonding and disposing the laminate body 10 to the upper surface 20a of the first support body 20, forming a first end surface 10a at the laminate body 10, and forming a first dielectric layer 17 on the first end surface 10a.

## Description

### TECHNICAL FIELD

The present disclosure relates to a manufacturing method for a semiconductor device, a semiconductor device, and a semiconductor apparatus.

### BACKGROUND OF INVENTION

Known manufacturing methods for semiconductor devices by which a semiconductor device is manufactured by mounting a semiconductor element such as a semiconductor laser element on a substrate are proposed. In particular, measures against difficulty in handling a semiconductor laser element when the semiconductor laser element is miniaturized are proposed (see Patent Document 1).

### CITATION LIST

### PATENT LITERATURE

Patent Document 1: JP 2008-252069 A

### SUMMARY

In the present disclosure, a manufacturing method for a semiconductor device includes preparing a laminate body including a plurality of semiconductor layers, and a first support body including an upper surface, a side surface, and a recessed portion including an opening adjacent to the upper surface and the side surface, bonding and disposing the laminate body to the upper surface of the first support body, forming a first end surface at the laminate body, and forming a first dielectric layer on the first end surface.

### BRIEF DESCRIPTION OF THE DRAWINGS

FIG. 1 is a flowchart illustrating a manufacturing method for a semiconductor device according to an embodiment of the present disclosure.
FIG. 2 is a perspective view schematically illustrating a configuration of a laminate body.
FIG. 3A is a cross-sectional view schematically illustrating an example of the laminate body.
FIG. 3B is a cross-sectional view schematically illustrating another example of the laminate body.
FIG. 4A is a perspective view schematically illustrating a first support body.
FIG. 4B is a plan view schematically illustrating the first support body.
FIG. 5A is a cross-sectional view schematically illustrating an example of the laminate body disposed on the first support body.
FIG. 5B is a cross-sectional view schematically illustrating another example of the laminate body disposed on the first support body.
FIG. 6 is a perspective view schematically illustrating the laminate body sandwiched between the first support body and a second support body.
FIG. 7 is a plan view for describing a forming process in the manufacturing method for the semiconductor device according to the embodiment of the present disclosure.
FIG. 8 is a plan view for describing a dividing process in the manufacturing method for the semiconductor device according to the embodiment of the present disclosure.
FIG. 9 is a cross-sectional view for describing a mask forming process in the manufacturing method for the semiconductor device according to another embodiment of the present disclosure.
FIG. 10 is a cross-sectional view for describing a growing process in the manufacturing method for the semiconductor device according to the other embodiment of the present disclosure.
FIG. 11 is a cross-sectional view for describing the growing process in the manufacturing method for the semiconductor device according to the other embodiment of the present disclosure.
FIG. 12 is a plan view schematically illustrating a first support substrate.
FIG. 13 is a cross-sectional view for describing a transferring process in the manufacturing method for the semiconductor device according to the other embodiment of the present disclosure.
FIG. 14 is a cross-sectional view for describing the transferring process in the manufacturing method for the semiconductor device according to the other embodiment of the present disclosure.
FIG. 15 is a plan view for describing the transferring process in the manufacturing method for the semiconductor device according to the other embodiment of the present disclosure.
FIG. 16 is a plan view for describing a cleaving process in the manufacturing method for the semiconductor device according to the other embodiment of the present disclosure.
FIG. 17 is a perspective view for describing a cutting process in the manufacturing method for the semiconductor device according to the other embodiment of the present disclosure.
FIG. 18 is a perspective view schematically illustrating a semiconductor device according to an embodiment of the present disclosure.
FIG. 19 is a plan view schematically illustrating the semiconductor device according to the embodiment of the present disclosure.
FIG. 20 is a perspective view schematically illustrating a variation of the semiconductor device according to the embodiment of the present disclosure.
FIG. 21 is a perspective view schematically illustrating a variation of the semiconductor device according to the embodiment of the present disclosure.
FIG. 22 is a perspective view schematically illustrating a variation of the semiconductor device according to the embodiment of the present disclosure.
FIG. 23 is a perspective view schematically illustrating a variation of the semiconductor device according to the embodiment of the present disclosure.
FIG. 24 is a perspective view schematically illustrating a variation of the semiconductor device according to the embodiment of the present disclosure.
FIG. 25 is a perspective view schematically illustrating a variation of the semiconductor device according to the embodiment of the present disclosure.
FIG. 26 is a perspective view schematically illustrating a variation of the semiconductor device according to the embodiment of the present disclosure.
FIG. 27 is a perspective view schematically illustrating a variation of the semiconductor device according to the embodiment of the present disclosure.
FIG. 28 is a perspective view schematically illustrating an example of a semiconductor apparatus according to an embodiment of the present disclosure.
FIG. 29 is a perspective view schematically illustrating another example of the semiconductor apparatus according to the embodiment of the present disclosure.
FIG. 30 is a flowchart illustrating the manufacturing method for the semiconductor device according to the present embodiment.
FIG. 31 is a perspective view illustrating the manufacturing method for the semiconductor device according to the present embodiment.
FIG. 32 is a flowchart illustrating the manufacturing method for the semiconductor device according to the present embodiment.
FIG. 33 is a plan view illustrating the manufacturing method for the semiconductor device according to the present embodiment.

### DESCRIPTION OF EMBODIMENTS

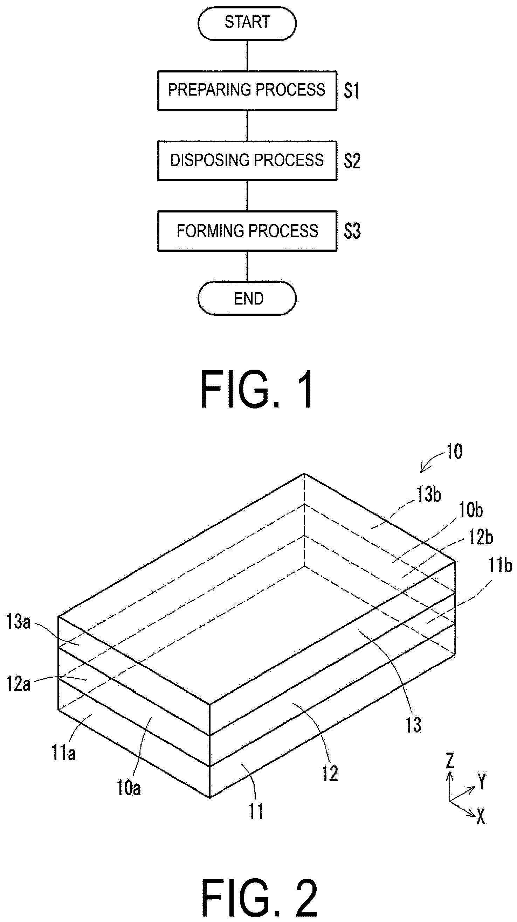

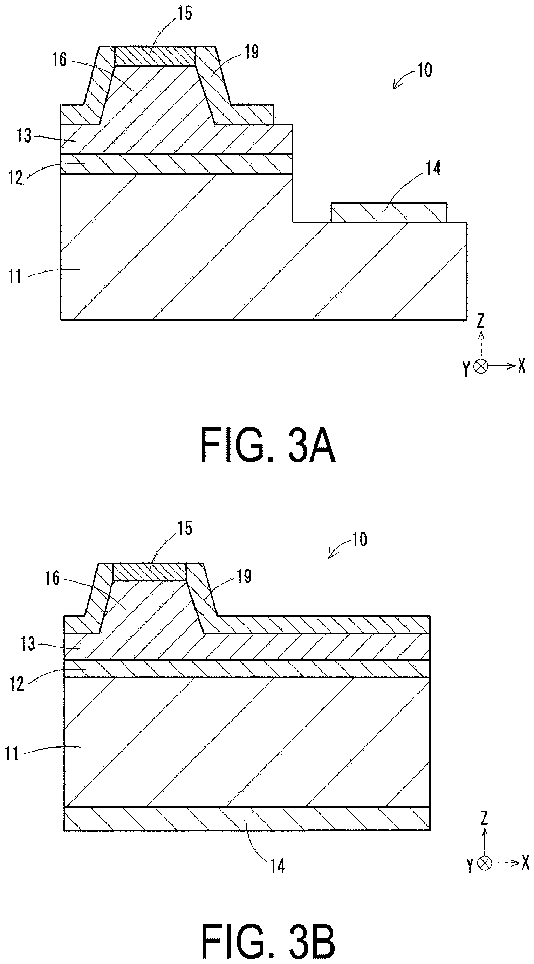

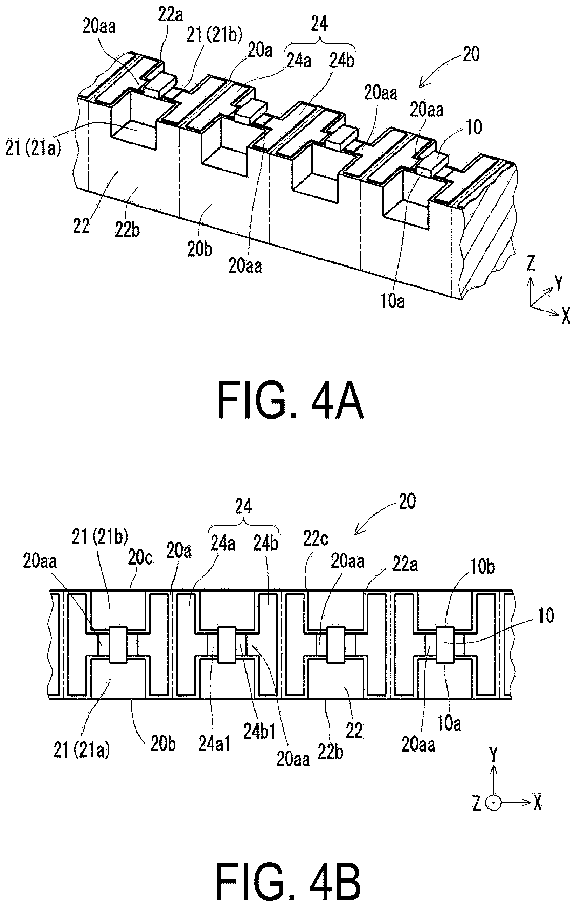

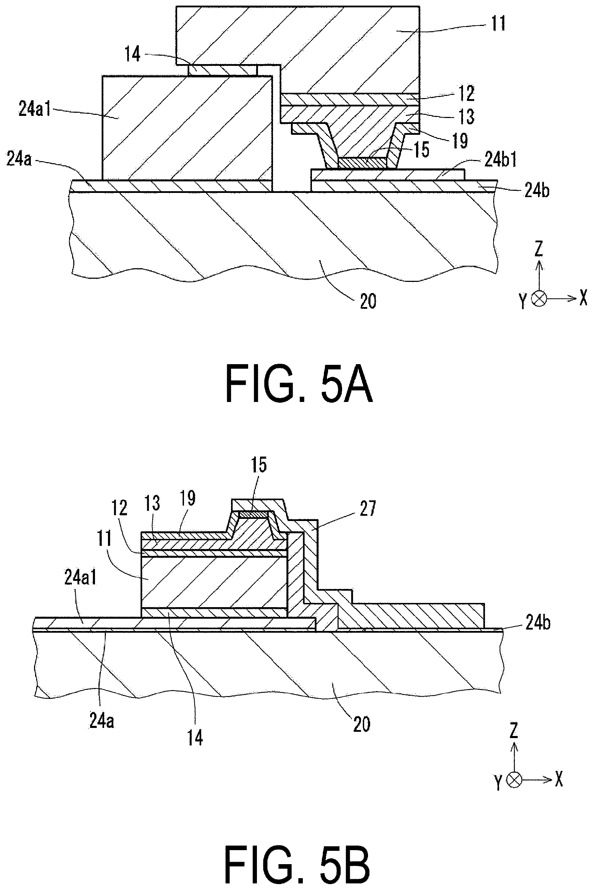

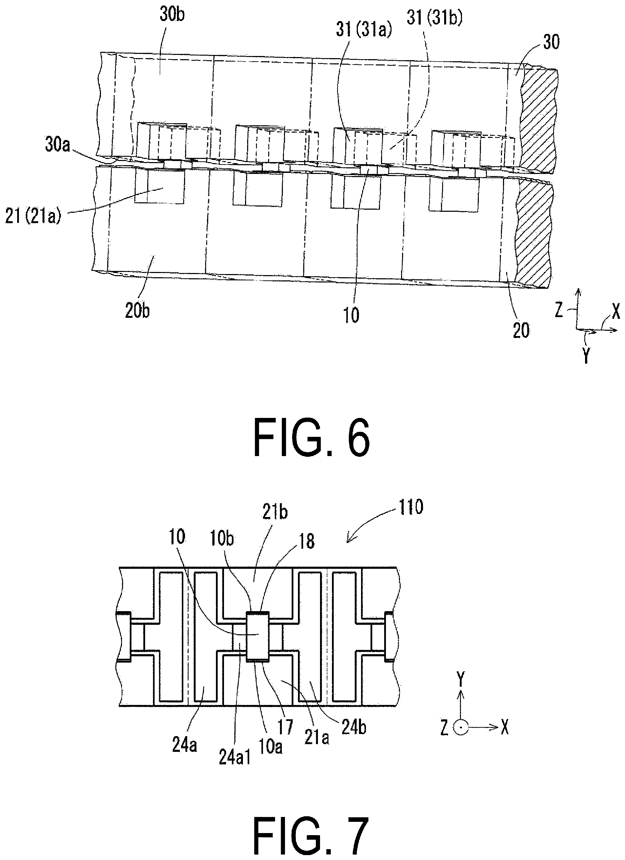

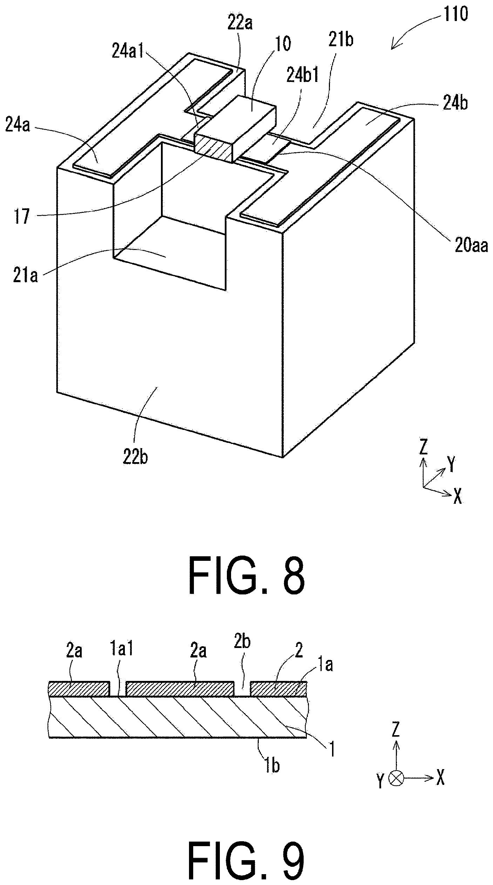

A manufacturing method for a semiconductor device according to an embodiment of the present disclosure will be described below with reference to the drawings. FIG. 1 is a flowchart illustrating the manufacturing method for the semiconductor device according to the embodiment of the present disclosure. FIG. 2 is a perspective view schematically illustrating a configuration of a laminate body, FIG. 3A is a cross-sectional view schematically illustrating an example of the laminate body, FIG. 3B is a cross-sectional view schematically illustrating another example of the laminate body, FIG. 4A is a perspective view schematically illustrating an example of a first support body, and FIG. 4B is a plan view schematically illustrating the example of the first support body. FIG. 5A is a cross-sectional view schematically illustrating an example of the laminate body disposed on the first support body, and FIG. 5B is a cross-sectional view schematically illustrating another example of the laminate body disposed on the first support body. FIG. 6 is a perspective view schematically illustrating an example of the first support body and a second support body, FIG. 7 is a plan view illustrating a forming process in the manufacturing method for the semiconductor device according to the embodiment of the present disclosure, and FIG. 8 is a plan view illustrating a dividing process in the manufacturing method for the semiconductor device according to the embodiment of the present disclosure. It is noted that in the present disclosure, terms such as "upper" and "lower" are used for convenience of description, and any direction may be regarded as an upper direction. Each of the drawings is given an orthogonal coordinate system XYZ for the sake of convenience of explanation.

The manufacturing method for the semiconductor device according to the present embodiment includes a preparing process S1, a disposing process S2, and a forming process S3 (see FIG. 1).

### (Preparing Process)

A preparing process S1 is a process of preparing a plurality of laminate bodies 10 and a first support body 20.

Each of the plurality of laminate bodies 10 may be a light emitting diode (LED) element, or may be a semiconductor laser (laser diode (LD)) element, for example. The manufacturing method for the semiconductor device according to the present embodiment exhibits a remarkable effect when the laminate body 10 is an edge-emitting LD element and forming a film of a dielectric layer or the like is required on an end surface. Hereinafter, a case where each of the plurality of laminate bodies 10 is an LD element will be described. The laminate body 10 may be a precursor of the LD element.

The laminate body 10 has a shape having a longitudinal direction along a resonance direction (a Y direction in FIG. 2). For example, as illustrated in FIG. 2, the laminate body 10 may have a substantially rectangular parallelepiped shape.
For example, as illustrated in FIG. 2, the laminate body 10 includes a plurality of semiconductor layers 11, 12, and 13. The plurality of semiconductor layers 11, 12, and 13 is layered in a direction orthogonal to the longitudinal direction of the laminate body 10. The semiconductor layers 11, 12, and 13 include first end surfaces 11a, 12a, and 13a, respectively. The plurality of first end surfaces 11a, 12a, and 13a may constitute a first resonator surface 10a of the laminate body 10. The semiconductor layers 11, 12, and 13 further include second end surfaces 11b, 12b, and 13b on an opposite side to the first end surfaces 11a, 12a, and 13a, respectively. The plurality of second end surfaces 11b, 12b, and 13b may constitute a second resonator surface 10b of the laminate body 10. Here, a resonator surface has a function of confining light inside the laminate body 10 by repeatedly reflecting light in a range in which light inductively emitted at the semiconductor layer is guided. Note that although FIG. 2 illustrates an example in which the laminate body 10 includes the three semiconductor layers 11, 12, and 13, the laminate body 10 may include four or more semiconductor layers. The laminate body 10 may have a length of, for example, 20 to 200 µm in a resonance direction. The length of the laminate body 10 in the resonance direction corresponds to a resonator length. When the resonator length is short, handling of the semiconductor laser element becomes difficult. A resonator length of a known semiconductor laser element that has been practically used is equal to or more than 300 µm as far as the inventors know. The manufacturing method for the semiconductor device according to the present embodiment can efficiently manufacture a semiconductor device on which the laminate body 10 having a short resonator length (the resonator length is, for example, equal to or less than 200 µm) is mounted.

The laminate body 10 may have a length of, for example, 5 to 100 µm in a laminate direction (a Z direction in FIG. 2). A thickness of the laminate body 10 may be 5 to 30 µm. In this case, when a resonator surface is formed by cleaving, the resonator length is easily shortened. The laminate body 10 may have a chip width of, for example, 30 to 400 µm. The chip width means the length of the laminate body 10 in a direction (an X direction in FIG. 2) orthogonal to both the resonance direction and the laminate direction. When the chip width is short, the number of laminate bodies 10 to be obtained from one wafer can be increased, which can improve manufacturing efficiency of the laminate bodies 10. However, when the chip width is reduced, handling of the semiconductor laser element becomes difficult same as, and/or similar to the case where the resonator length is reduced. Because of this, a known semiconductor laser element has a chip width of about 100 µm. The manufacturing method for the semiconductor device according to the present embodiment can efficiently manufacture a semiconductor device on which the laminate body 10 having a short chip width (for example, 30 to 100 µm) is mounted.

As described above, the manufacturing method for the semiconductor device according to the present embodiment can efficiently manufacture a semiconductor device on which the laminate body 10 having a short resonator length or chip width is mounted.
Thus, in the production of the laminate body 10, the number of laminate bodies 10 to be obtained from one wafer can be increased, which can improve the manufacturing efficiency of the laminate body 10. Accordingly, the manufacturing efficiency of the semiconductor device can be improved. Note that the laminate body 10 may have the resonator length being shorter than the chip width. In this case, a direction of the chip width serves as the longitudinal direction of the laminate body 10.

The plurality of semiconductor layers 11, 12, and 13 may include a first semiconductor layer 11, an active layer 12, and a second semiconductor layer 13, respectively. The first semiconductor layer 11, the active layer 12, and the second semiconductor layer 13 are made of a GaN-based semiconductor such as gallium nitride (GaN), aluminum gallium nitride (AlGaN), indium gallium nitride (InGaN), or aluminum indium gallium nitride (AlInGaN). Here, the "GaN-based semiconductor" is composed of, for example, AlₓGa_{y}In_{z}N (0 ≤ x ≤ 1; 0 ≤ y ≤ 1; 0 ≤ z ≤ 1; x + y + z = 1).

The first semiconductor layer 11 may be made of an n-type GaN-based semiconductor doped with an n-type impurity. The second semiconductor layer 13 may be made of a p-type GaN-based semiconductor doped with a p-type impurity. As the n-type impurity, for example, Si, Ge, Sn, S, O, Ti, Zn, Cd, or the like can be used. As the p-type impurity, for example, Mg, Zn, Be, Mn, Ca, Sr, or the like can be used.

The active layer 12 may have a multiple quantum well structure in which barrier layers and well layers are alternately layered. The GaN-based semiconductor constituting the barrier layer and the GaN-based semiconductor constituting the well layer may differ in composition or composition ratio from each other.

The laminate body 10 may have a single-sided electrode structure, for example, as illustrated in FIG. 3A, or may have a double-sided electrode structure, for example, as illustrated in FIG. 3B. For example, as illustrated in FIG. 3A and FIG. 3B, the laminate body 10 may include a first electrode (also referred to as an n-type electrode) 14 connected to the first semiconductor layer 11 and a second electrode (also referred to as a p-type electrode) 15 connected to the second semiconductor layer 13.

The laminate body 10 may include a ridge waveguide 16 made by partially removing the second semiconductor layer 13. An insulating film 19 made of SiO₂ or the like may be provided on the partially removed portion of the second semiconductor layer 13 and a side surface of the ridge waveguide 16. The laminate body 10 may include a ridge waveguide provided on the first semiconductor layer 11 side.

When the laminate body 10 has a single-sided electrode structure (see FIG. 3A), the laminate body 10 may be removed from the second semiconductor layer 13 side until the first semiconductor layer 11 is exposed, and the n-type electrode 14 may be disposed on the exposed surface of the first semiconductor layer 11. In this case, both a surface of the first semiconductor layer 11 connected to the n-type electrode 14 and a surface of the second semiconductor layer 13 connected to the p-type electrode 15 can serve as a (0001) plane of the GaN-based semiconductor.

Here, when a substrate for crystal growth of a semiconductor layer to serve as a semiconductor laser element has electrical conductivity, a GaN-based nitride semiconductor laser element may have a double-sided electrode structure in which the semiconductor layer is grown in a manner that one surface is a (0001) plane and the other surface is a (000-1) plane, and a p-type electrode is in contact with the one surface that is the (0001) plane and an n-type electrode is in contact with the other surface that is the (000-1) plane. This causes the semiconductor laser element having the double-sided electrode structure to avoid the problems with the semiconductor laser element having the single-sided electrode structure that a current is caused to flow in a lateral direction between the p-type electrode and the n-type electrode, and as a result, the current non-uniformly flows in the ridge waveguide, resulting in an increase in threshold current or an increase in drive voltage when a current path is longer than that with the double-sided electrode structure.

On the other hand, as for a contact resistance between the semiconductor layer and the electrode, a contact resistance when the electrode is brought into contact with the (000-1) plane is higher than a contact resistance when the electrode is brought into contact with the (0001) plane. Thus, various planes different from the (000-1) plane may be exposed by performing processing such as etching on the back surface that is the (000-1) plane.

The manufacturing method for the semiconductor device according to the present embodiment has an advantage that the laminate body 10 has the single-sided electrode structure even when the laminate body 10 can have the double-sided electrode structure for the following reason. That is, the manufacturing method for the semiconductor device according to the present embodiment makes it possible to handle the laminate body 10 having a chip width smaller than that of a known semiconductor laser element. Thus, even in the laminate body 10 having the single-sided electrode structure, the current path between the n-type electrode 14 and the p-type electrode 15 can be shortened. In the known semiconductor laser element having the double-sided electrode structure, a length of the current path between an n-type electrode and a p-type electrode is about 100 µm, which is substantially the same as a chip thickness of the semiconductor laser element. According to the manufacturing method for the semiconductor device according to the present embodiment, the chip width of the laminate body 10 can be set to 30 to 100 µm. Thus, even the laminate body 10 having the single-sided electrode structure can have the length of the current path being substantially equal to or less than that of the typical semiconductor laser element having the double-sided electrode structure. Even when the length of the current path of the laminate body 10 having the single-sided electrode structure is longer than the length of the current path of the typical semiconductor laser element having the double-sided electrode structure, the length of the current path is a length that affects a series resistance of the laminate body 10. Since the resonator length of the laminate body 10 is short, a drive current is small, and the laminate body 10 can be driven near the threshold current unless a high optical output is required. Thus, the series resistance that causes an increase in voltage according to a value of the drive current does not cause a major problem for the laminate body 10. In the laminate body 10 having the single-sided electrode structure, both the surface connected to the n-type electrode 14 and the surface connected to the p-type electrode 15 can serve as the (0001) plane, which can reduce a contact resistance.

The laminate body 10 can include a surface having a crystal orientation different from the (0001) plane and the (000-1) plane. The laminate body 10 can include surfaces of crystal orientations generally known about GaN-based semiconductors, such as a (20-21) plane, a (11-22) plane, and a (10-10) plane.
The surface of the laminate body 10 serving as the (0001) plane can improve the manufacturing efficiency of the semiconductor device.

### (Disposing Process)

In the disposing process S2, the plurality of laminate bodies 10 is disposed on the first support body 20. A shape of the first support body 20 may be a substantially quadrilateral prism shape (a substantially rectangular parallelepiped shape), a substantially pentagonal prism shape, a substantially hexagonal prism shape, or the like, or may be other shapes. In the present embodiment, for example, as illustrated in FIG. 4A and FIG. 4B, the shape of the first support body 20 is a substantially rectangular parallelepiped shape. The first support body 20 may be made of an insulating material or a semi-insulating material, or may be made of an electrically conductive material. Examples of the insulating material or the semi-insulating material to be used for the first support body 20 include Si, SiC, and AlN. Examples of the electrically conductive material to be used for the first support body 20 include metal materials containing Cu, and Al.

The first support body 20 includes an upper surface 20a, a first side surface 20b, and a second side surface 20c. The upper surface 20a, the first side surface 20b, and the second side surface 20c are surfaces extending in a longitudinal direction of the first support body 20. The first side surface 20b is continuous with the upper surface 20a. The second side surface 20c is continuous with the upper surface 20a, and is positioned on an opposite side to the first side surface 20b.

As illustrated in FIG. 4A and FIG. 4B, for example, the first support body 20 includes a recessed portion 21. The recessed portion 21 may be opened to the upper surface 20a and the first side surface 20b or may be opened to the upper surface 20a and the second side surface 20c. In other words, the recessed portion 21 may be adjacent to the upper surface 20a and the first side surface 20b, or may be adjacent to the upper surface 20a and the second side surface 20c.
The first support body 20 may include the plurality of recessed portions 21.

The plurality of recessed portions 21 may include a plurality of first recessed portions 21a and a plurality of second recessed portions 21b. The plurality of first recessed portions 21a may be opened to the upper surface 20a and the first side surface 20b, and may be aligned in a row along the longitudinal direction of the first support body 20. The plurality of second recessed portions 21b may be opened to the upper surface 20a and the second side surface 20c, and may be aligned in a row along the longitudinal direction of the first support body 20. Each of the plurality of first recessed portions 21a and a corresponding one of the plurality of second recessed portions 21b may overlap each other in a side view (when viewed in a direction orthogonal to the first side surface 20b).

As illustrated in FIG. 4A and FIG. 4B, for example, the first support body 20 may include a plurality of substrate regions 22 aligned in a row in the longitudinal direction of the first support body 20. Each substrate region 22 may have a substantially cubic shape, a substantially rectangular parallelepiped shape, or the like, or may have any other shape. In the present embodiment, each substrate region 22 has a substantially rectangular parallelepiped shape.

Each substrate region 22 includes a first surface 22a, a second surface 22b continuous with the first surface 22a, and a third surface 22c on an opposite side to the second surface 22b. The first surface 22a, the second surface 22b, and the third surface 22c are exposed surfaces exposed to the outside. The upper surface 20a, the first side surface 20b, and the second side surface 20c of the first support body 20 respectively include the first surface 22a, the second surface 22b, and the third surface 22c of each substrate region 22. Each substrate region 22 includes at least one recessed portion 21. Each substrate region 22 may include at least one first recessed portion 21a and at least one second recessed portion 21b.

A wiring 24 made of an electrically conductive material is routed on the upper surface 20a of the first support body 20. In other words, the first support body 20 may function as a wiring board. The wiring 24 may be a continuous wiring. The wiring 24 may include a first wiring 24a and a second wiring 24b that are disposed on the first surface 22a of each substrate region 22. The first wiring 24a and the second wiring 24b may be disposed in a separated manner from each other. The first wiring 24a may include a bonding member 24a1 electrically connected to an n-type electrode 14 of the laminate body 10. The second wiring 24b may include a bonding member 24b1 electrically connected to a p-type electrode 15 of the laminate body 10. When the first support body 20 is made of an electrically conductive material, an insulating layer may be disposed on the upper surface 20a of the first support body 20, and the wiring 24 may be disposed on the insulating layer. This can suppress a short circuit between the wirings 24, which can cause the semiconductor device to normally operate. The wiring 24 may have a configuration in which the first wiring 24a of one substrate region 22 and the second wiring 24b of the substrate region 22 adjacent to the one substrate region 22 are connected to each other.

The wiring 24 may include a metal layer made of, for example, Au, Ti, Ni, or the like. The wiring 24 may be made of a single metal layer or multiple metal layers. When the wiring 24 is constituted by multiple metal layers, the outermost surface may be a metal layer made of Au. This can suppress corrosion of the wiring 24. The bonding members 24a1 and 24a2 are electrically conductive bonding members such as solder. The bonding members 24a1 and 24a2 may be made of solder such as AuSi, AuSn or the like, for example. Without providing the bonding members 24a1 and 24b1, the n-type electrode 14 and the p-type electrode 15 of the laminate body 10 may be respectively bonded to the first wiring 24a and the second wiring 24b by using metal-metal bonding such as Au-Au bonding, surface-activation bonding, or the like.

In the disposing process S2, the plurality of laminate bodies 10 are disposed on the first support body 20 while the first end surfaces 11a, 12a, and 13a (the first resonator surface 10a) are exposed. Thus, in the forming process S3, a first dielectric layer can be excellently formed on the first resonator surface 10a. As a result, when the first resonator surface 10a is a reflection surface for laser beam, reflection efficiency at the first resonator surface 10a can be increased and the laminate body 10 having excellent light emission efficiency can be obtained. When the first resonator surface 10a is an emission surface of laser beam, optical damage to the end surface can be suppressed and the laminate body 10 having excellent reliability can be obtained.

In production of a semiconductor laser element, a dielectric layer on each of end surfaces of a plurality of semiconductor laser element precursors needs to be film-formed (also referred to as "end surface coating"), and the end surfaces need to serve as resonator surfaces having a desired reflectance. Typically, the end surface coating is performed while the plurality of semiconductor laser element precursors are connected in a bar shape. In the manufacturing method for the semiconductor device according to the present embodiment, even when a plurality of laminate bodies 10 is singulated, the end surface coating can be appropriately performed by using the first support body 20. Note that the reflection surface and the emission surface have different reflectances, and the resonator surface having the lower reflectance is used as the emission surface of a laser beam, and an external device uses the laser beam emitted from the emission surface. A structure and a film thickness of the dielectric layer, a type of a dielectric material constituting the dielectric layer, and the like can be used for controlling the reflectance of the reflection surface and the reflectance of the emission surface.

When the first support body 20 includes the plurality of recessed portions 21, the plurality of laminate bodies 10 may be disposed corresponding to the plurality of recessed portions 21. The upper surface 20a according to the present embodiment includes a mounting region 20aa having a strip shape. The mounting region 20aa having the stripe shape is narrowed in a short-side direction of the first support body 20 by forming the recessed portion 21 in the first support body 20, and as a result, has the strip shape. At this time, for example, as illustrated in FIG. 4A and FIG. 4B, the plurality of laminate bodies 10 may be individually disposed in the mounting region 20aa having the stripe shape of the upper surface 20a. This makes it easy to dispose the plurality of laminate bodies 10 on the first support body 20 while exposing the first end surfaces 11a, 12a, and 13a. Since the plurality of laminate bodies 10 is disposed at partially thinned portions of the first support body 20, the first support body 20 can have high mechanical strength as a whole and can have excellent handling performance. Note that at this time, when viewed in a direction orthogonal to the first side surface 20b, the first end surfaces 11a, 12a, and 13a are positioned above the recessed portion 21.

When the first support body 20 includes the plurality of first recessed portions 21a and the plurality of second recessed portions 21b, each of the plurality of laminate bodies 10 may be disposed between a respective one of the plurality of first recessed portions 21a and a respective one of the plurality of second recessed portions 21b. This makes it easy to dispose each of the plurality of laminate bodies 10 on the first support body 20 while exposing the first resonator surface 10a and the second resonator surface 10b. Since the plurality of laminate bodies 10 is disposed at partially thinned portions of the first support body 20, the first support body 20 can have high mechanical strength as a whole and can have excellent handling performance.

In the disposing process S2, the first end surfaces 11a, 12a, and 13a of each of the plurality of laminate bodies 10 may be disposed in a manner that each of the plurality of laminate bodies 10 is positioned outside the mounting region 20aa. To be specific, in the disposing process S2, the plurality of laminate bodies 10 may be disposed in a manner that the first resonator surface 10a and the second resonator surface 10b of each of the plurality of laminate bodies 10 protrude outward relative to the mounting region 20aa in a plan view. In the disposing process S2, the laminate body 10 may be disposed in a manner that the first end surfaces 11a, 12a, and 13a are positioned on the mounting region 20aa, as long as light emitted from the laminate body 10 does not hit the upper surface 20a and the end surface coating in the forming process S3 can be appropriately performed.

In the disposing process S2, for example, as illustrated in FIG. 5A and FIG. 5B, the n-type electrode 14 and the p-type electrode 15 of the laminate body 10 may be respectively electrically connected to the first wiring 24a and the second wiring 24b that are disposed on the upper surface 20a of the first support body 20 with the bonding members 24a1 and 24b 1 interposed therebetween. The laminate body 10 may be mechanically fixed to the first support body 20 by connecting the n-type electrode 14 to the first wiring 24a and connecting the p-type electrode 15 to the second wiring 24b.

By electrically connecting and mechanically fixing the laminate body 10 and the first support body 20 to each other, the first support body 20 functions not only as a jig in the forming process S3 but also as a submount in the semiconductor device. In a typical manufacturing method for a semiconductor device, each of laminate bodies needs to be handled and mounted on a submount, and thus, the laminate body needs to have a size (a resonator length and a chip width) large enough to be sucked by a collet, which makes it difficult to reduce the size. According to the manufacturing method for the semiconductor device according to the present embodiment, the size of the laminate body can be significantly reduced.

When the laminate body 10 has a single-sided electrode structure, for example, as illustrated in FIG. 5A, the n-type electrode 14 and the first wiring 24a may be bonded to each other by the bonding member 24a1, and the p-type electrode 15 and the first wiring 24b may be bonded to each other by the bonding member 24b 1.

In FIG. 5A, a thickness of the bonding member 24a1 is greater than a thickness of the bonding member 24b1, but the thickness of the bonding member 24a1 and the thickness of the bonding member 24b1 can be made to be approximately equal to each other by making a thickness of the n-type electrode 14 greater. A step may be formed at the first surface 22a of the substrate region 22, and thereby, a height position of a portion where the first wiring 24a is provided is made higher than a height position of a portion where the second wiring 24b is provided. In this case, a possibility that the bonding member 24a1 and the bonding member 24b1 are short-circuited can be reduced.

When the laminate body 10 has a double-sided electrode structure, for example, as illustrated in FIG. 5B, the n-type electrode 14 and the first wiring 24a may be connected to each other by the bonding member 24a1, and the p-type electrode 15 and the second wiring 24b may be connected to each other by a wiring electrode 27. An insulating film 28 made of an insulating material may be disposed between the wiring electrode 27, and the plurality of semiconductor layers 11, 12, and 13 and the bonding member 24a1. In this case, the possibility that the plurality of semiconductor layers 11, 12, and 13 and the bonding member 24a1 are short-circuited to the wiring electrode 27 can be reduced. In this case, the second semiconductor layer 13 may be positioned on a side of the laminate body 10 to be bonded to the first support body 20, and the ridge waveguide 16 may be provided on the first semiconductor layer 11 side.

Note that a resin layer may be disposed on the upper surface 20a of the first support body 20, and the laminate body 10 may be bonded to the first support body 20 with the resin layer interposed therebetween.

In the disposing process S2, for example, as illustrated in FIG. 6, the second support body 30 may be prepared, and the plurality of laminate bodies 10 may be sandwiched and disposed between the first support body 20 and the second support body 30. Thus, in the forming process S3, the first dielectric layer 17 can be formed on the first resonator surface 10a while the laminate body 10 is firmly fixed to the first support body 20 and the second support body 30, which can form the first dielectric layer 17 whose layer thickness is controlled with high accuracy. As a result, the laminate body 10 can be a laminate body excellent in light emission efficiency or a laminate body excellent in reliability. Variations in light emission characteristics of the laminate body 10 can be suppressed and a manufacturing yield of the semiconductor device can be improved.

The second support body 30 may have a substantially quadrangular prism shape (a substantially rectangular parallelepiped shape), a substantially pentagonal prism shape, a substantially hexagonal prism shape, or the like, or may have other shapes. In the present embodiment, for example, as illustrated in FIG. 6, the second support body 30 may have a substantially rectangular parallelepiped shape. Also, the second support body 30 may have the same shape as that of the first support body. The second support body 30 may be made of an insulating material or a semi-insulating material, or may be made of an electrically conductive material. As the insulating material or the semi-insulating material, for example, Si, SiC, AlN, or the like can be used. For example, a metal material such as Cu, or Al may be used as an electrically conductive material. The second support body 30 may contain the same material as that of the first support body 10.

The second support body 30 includes a lower surface 30a, a first side surface 30b, and a second side surface 30c. The lower surface 30a, the first side surface 30b, and the second side surface 30c extend in the longitudinal direction of the second support body 30. The first side surface 30b and the second side surface 30c are continuous with the lower surface 30a, and the second side surface 30c is positioned on the opposite side to the first side surface 30b.

The second support body 30 may include a plurality of recessed portions 31. The plurality of recessed portions 31 may be opened to the lower surface 30a and the first side surface 30b or may be opened to the lower surface 30a and the second side surface 30c. In other words, the plurality of recessed portions 31 may be adjacent to the lower surface 30a and the first side surface 30b, or may be adjacent to the lower surface 30a and the second side surface 30c. The plurality of recessed portions 31 may include a plurality of third recessed portions 31a and a plurality of fourth recessed portions 31b. The plurality of third recessed portions 31a may be opened to the lower surface 30a and the first side surface 30b and be aligned in a row along the longitudinal direction of the second support body 30. The plurality of fourth recessed portions 31b may be opened to the lower surface 30a and the second side surface 30c and be aligned in a row along the longitudinal direction of the second support body 30. Each of the plurality of third recessed portions 31a and a corresponding one of the plurality of fourth recessed portions 31b may overlap each other in a side view (when viewed in a direction orthogonal to the first side surface 30b).

When the second support body 30 includes the plurality of recessed portions 31, the plurality of laminate bodies 10 may be disposed corresponding to the plurality of recessed portions 31. In other words, each of the plurality of laminate bodies 10 may be disposed at a respective one of a plurality of portions of the lower surface 30a each of which is formed with the recessed portion 31 and whose widths in the short-side direction are narrowed. At this time, the first support body 20 and the second support body 30 may be positioned in a manner that the first resonator surface 10a of each of the plurality of laminate bodies 10 is exposed in a respective one of the plurality of recessed portions 21 of the first support body 20, and is exposed in a respective one of the plurality of recessed portions 31 of the second support body 30. Accordingly, the first resonator surface 10a of each laminate body 10 is not disposed at a deep position between the first support body 20 and the second support body 30, and is completely exposed in the recessed portions 21 and 31. As a result, the first dielectric layer can be excellently formed on the first resonator surface 10a of the laminate body 10. Consequently, the laminate body 10 can be a laminate body excellent in light emission efficiency or a laminate body excellent in reliability. Since each of the plurality of laminate bodies 10 is disposed at the partially thinned portion of the second support body 30, the second support body 30 can be made to have high mechanical strength as a whole and excellent handling performance.

When the second support body 30 includes the plurality of third recessed portions 31a and the plurality of fourth recessed portions 31b, each of the plurality of laminate bodies 10 may be disposed between a respective one of the plurality of third recessed portions 31a and a respective one of the plurality of fourth recessed portions 31b. Thus, the first resonator surface 10a and the second resonator surface 10b of each laminate body 10 can be completely exposed between the first support body 20 and the second support body 30. As a result, the first dielectric layer can be excellently formed on the first resonator surface 10a, and the second dielectric layer can be excellently formed on the second resonator surface 10b. Consequently, the laminate body 10 can be a laminate body having excellent light emission efficiency and excellent reliability. Since each of the plurality of laminate bodies 10 is disposed at the partially thinned portion of the second support body 30, the second support body 30 can be made to have high mechanical strength as a whole and excellent handling performance.

No wiring may be disposed on the lower surface 30a of the second support body 30, and a resin layer may be disposed on the lower surface 30a. In the disposing process S2, the plurality of laminate bodies 10 may be fixed to the second support body 30 with the resin layer disposed on the lower surface 30a interposed therebetween. Accordingly, the possibility that the laminate body 10 comes into contact with the wiring and is damaged can be reduced. Note that the plurality of laminate bodies 10 do not need to be fixed to the second support body 30, and may be in contact with the second support body 30 with the resin layer disposed on the lower surface 30a interposed therebetween.

The first support body 20 and the second support body 30 may be brought into contact with each other and then, positioned, or may be spaced apart from each other and then, positioned. At least one of the first support body 20 or the second support body 30 may include a region protruding more than the regions where the plurality of laminate bodies 10 is disposed. In the disposing process S2, the first support body 20 and the second support body 30 may be brought into contact with each other in the protruding region. A height of the protruding region may be higher than a height of the laminate body 10 from the upper surface 20a. Accordingly, the possibility that the laminate body 10 is damaged when the first support body 20 and the second support body 30 are brought close to each other can be reduced in the disposing process S2.

Although not illustrated, the plurality of laminate bodies 10 may be further disposed on the upper surface of the second support body 30 on the side opposite to the lower surface 30a. In this case, since a dielectric layer can be formed on a greater number of laminate bodies 10, the semiconductor device can be efficiently manufactured.

Note that the plurality of laminate bodies 10 may be a plurality of laminate bodies grown on an underlying substrate (substrate for crystal growth) by using an epitaxial lateral overgrowth (ELO) method. In this case, after the plurality of laminate bodies 10 connected to the underlying substrate is bonded to the first support body 20, the plurality of laminate bodies 10 may be peeled off from the underlying substrate through the first support body 20. Thus, the plurality of laminate bodies 10 can be disposed on the first support body 20 at the same time, and thus, the manufacturing efficiency of the semiconductor device can be further improved. Since alignment accuracy of the plurality of laminate bodies 10 is improved, when the first support body 20 is used as a submount of the semiconductor device, variations in distribution characteristics of light emitted from the plurality of laminate bodies 10 can be suppressed, compared to a case where each laminate body is individually mounted on a submount. This is a significant advantage when the distribution characteristics of light emitted from the plurality of laminate bodies 10 are required to be controlled with high accuracy or when the semiconductor device is coupled to a waveguide of an external device. When the plurality of laminate bodies 10 are peeled off from the underlying substrate, the plurality of semiconductor layers 10 do not include the underlying substrate. As a result, the thicknesses of the plurality of laminate bodies 10 can be reduced.

### (Forming Process)

In the forming process S3, the first dielectric layer 17 is formed on the first resonator surface 10a of the laminate body 10. The first dielectric layer 17 is made of a dielectric material. Examples of the dielectric material to be used for the first dielectric layer 17 include SiO₂, Al₂O₃, AlN, AlON, Nb₂O₅, TazOs, and ZrO₂. The first dielectric layer 17 may be a multilayer film made of the above-described dielectric material. The first dielectric layer 17 can be formed by using a film forming apparatus such as an electron beam vapor deposition apparatus, an electron cyclotron resonance sputtering apparatus, or a chemical vapor deposition apparatus.

Forming the first dielectric layer 17 on the first resonator surface 10a of the laminate body 10 can cause the laminate body 10 to be a laminate body excellent in light emission efficiency or a laminate body excellent in reliability. In the forming process S3, for example, as illustrated in FIG. 7, not only may the first dielectric layer 17 be formed on the first resonator surface 10a, but also the second dielectric layer 18 may be formed on the second resonator surface 10b (the second end surfaces 11b, 12b, and 13b of the plurality of semiconductor layers). Thus, the laminate body 10 can be a laminate body excellent in light emission efficiency and excellent in reliability.

Same as and/or similar to the first dielectric layer 17, the second dielectric layer 18 may be made of a dielectric material such as SiO₂, Al₂O₃, AlN, AlON, Nb₂O₅, TazOs, or ZrO₂, for example. The second dielectric layer 18 may be a multilayer film. Same as and/or similar to the first dielectric layer 17, the second dielectric layer 18 can be formed by using a film forming apparatus such as an electron beam vapor deposition apparatus, an electron cyclotron resonance sputtering apparatus, or a chemical vapor deposition apparatus. The first dielectric layer 17 and the second dielectric layer 18 may have the same configuration or may have different configurations.

### (Dividing Process)

In the manufacturing method for the semiconductor device according to the present embodiment, the dividing process S4 may be performed after performing the forming process S3. The dividing process S4 is a process of dividing the first support body 20 and then forming a plurality of substrates 110 (see FIG. 8) each of which is disposed with a respective one of the plurality of laminate bodies 10. The substrate 110 can be used as a substrate (also referred to as a submount) of a semiconductor device 100.

In the dividing process S4, a known cutting method such as dicing or scribing can be used. In the dividing process S4, any portion of the first support body 20 may be cut as long as the plurality of laminate bodies 10 are not damaged. The substrate 110 may include one substrate region 22, or may include two or more substrate regions 22.

In the dividing process S4, both the first support body 20 and the second support body 30 may be cut while the plurality of laminate bodies 10 are sandwiched between the first support body 20 and the second support body 30, and the divided pieces of the second support body 30 may be removed. The semiconductor device may be provided with the divided pieces of the first support body 50 and the divided pieces of the second support body 30 without removing the divided pieces of the second support body 30.

In the dividing process S4, the second support body 30 used in the forming process S3 may be removed, and only the first support body 20 disposed with the plurality of laminate bodies 10 may be cut. The second support body 30 may be reused in the next forming process S3.

For example, as illustrated in FIG. 4A and FIG. 4B, when a plurality of wirings 24 separated from each other are routed on the upper surface 20a of the first support body 20, the first support body 20 may be divided in a region exposed between the plurality of wirings 24 in the dividing process S4. When the wiring 24 is a continuous wiring, both the first support body 20 and the wiring 24 may be cut in the dividing process S4.

According to the above-described manufacturing method for the semiconductor device, the first support body 20 used for forming the first dielectric layer 17 on the first resonator surface 10a of the laminate body 10 is used as a substrate (submount) of the semiconductor device. Thus, the semiconductor device can be efficiently manufactured. Since a die bonding process of separating the laminate body 10 formed with the first dielectric layer 17 on the first resonator surface 10a from the first support body 20 and mounting the laminate body 10 on a substrate prepared separately from the first support body 20 is not required, the possibility that the laminate body 10 is damaged can be reduced. As a result, the semiconductor device having excellent reliability can be manufactured, and the manufacturing yield can be improved. Since the die bonding process is not necessary, the size of the laminate body 10 can be reduced as compared with the related art. Since adopting such a laminate body 10 can increase the number of laminate bodies 10 to be obtained from one wafer, the manufacturing efficiency of the laminate body 10 can be improved, and the manufacturing efficiency of the semiconductor device can be improved. Since adopting such a laminate body 10 can reduce power consumption by shortening the resonator length, the laminate body 10 is suitable for applications such as augmented reality (AR) glasses for which low optical output, low power consumption, and the like are required.

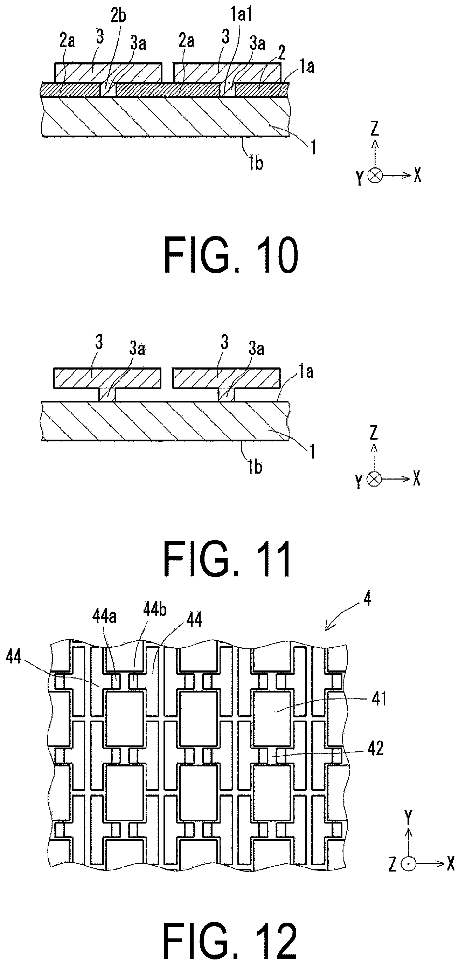

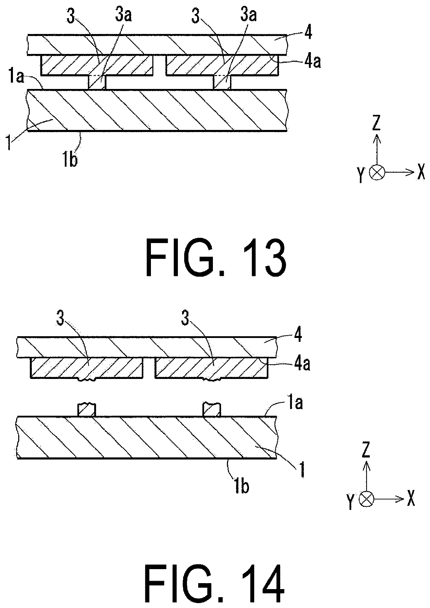

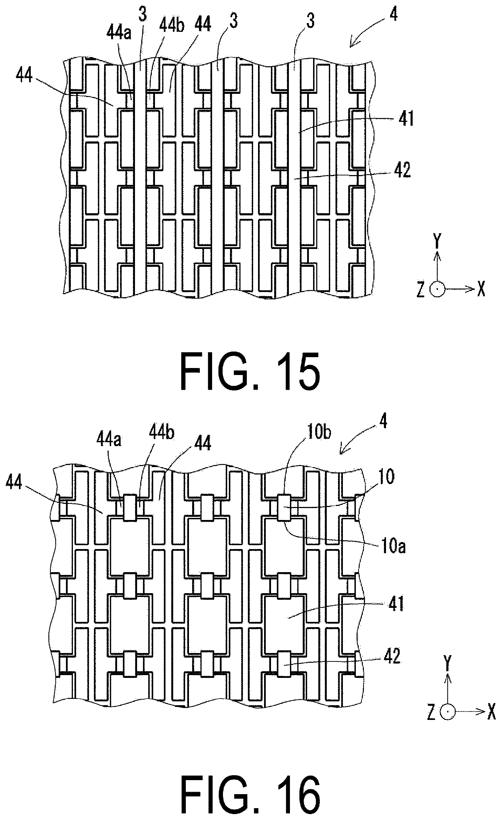

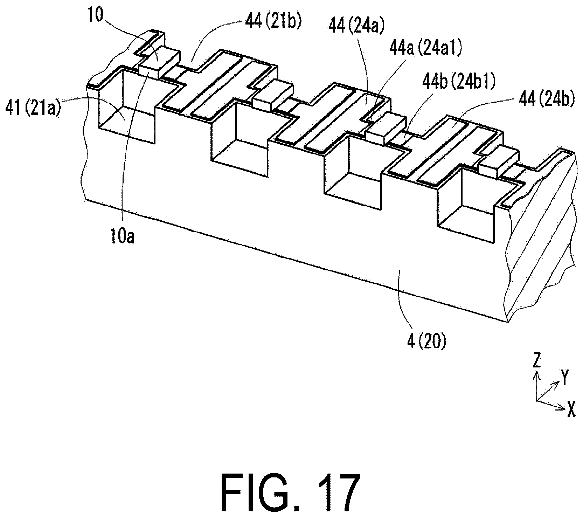

A manufacturing method for a semiconductor device according to another embodiment of the present disclosure will be described. FIG. 9 is a cross-sectional view illustrating a mask forming process in a manufacturing method for a semiconductor device according to another embodiment of the present disclosure, FIGs. 10, and 11 are cross-sectional views illustrating a growing process in the manufacturing method for the semiconductor device according to the other embodiment of the present disclosure, and FIG. 12 is a plan view schematically illustrating a first support substrate. FIGs. 13, and 14 are cross-sectional views illustrating a transferring process in the manufacturing method for the semiconductor device according to the other embodiment of the present disclosure, FIG. 15 is a plan view illustrating the transferring process in the manufacturing method for the semiconductor device according to the other embodiment of the present disclosure, FIG. 16 is a plan view illustrating a cleaving process in the manufacturing method for the semiconductor device according to the other embodiment of the present disclosure, and FIG. 17 is a perspective view illustrating a cutting process in the manufacturing method for the semiconductor device according to the other embodiment of the present disclosure.

The preparing process S1 and the disposing process S2 in the manufacturing method for the semiconductor device according to the embodiment of the present disclosure can be replaced with a preparing process S11, a mask forming process S12, a growing process S13, a transferring process S14, a cleaving process S15, and a cutting process S16, which will be described below.

### (Preparing Process)

The preparing process S11 is a process of preparing an underlying substrate 1. The underlying substrate 1 includes one main surface 1a including a growth starting point of a semiconductor element layer 3 serving as a precursor of the laminate body 10. The underlying substrate 1 may be, for example, a gallium nitride (GaN) substrate, a sapphire (Al2O3) substrate, a silicon (Si) substrate, a silicon carbide (SiC) substrate, or the like. Hereinafter, an example in which a GaN substrate is used as the underlying substrate 1 will be described. In the present specification, the GaN substrate refers to a substrate in which the one main surface 1a including the growth starting point of the semiconductor element layer 3 or a substrate in which a surface layer including the one main surface 1a is made of a GaN-based semiconductor. Thus, the GaN substrate may be a substrate where a layer made of a GaN-based semiconductor is formed on a surface of a sapphire substrate, a Si substrate, a SiC substrate, or the like. In particular, when the underlying substrate 1 is a Si substrate, an underlying substrate with a large diameter can be prepared at low cost, which can reduce the manufacturing cost of the semiconductor device.

### Mask Forming Process

The mask forming process S12 is a process of forming a mask 2 that suppresses growth of the semiconductor element layer 3, in a predetermined periodic pattern on the one main surface 1a of the underlying substrate 1. The semiconductor element layer 3 grows from a growth region 1a1 of the one main surface 1a that is not covered with the mask 2. The mask 2 is made of, for example, SiO2, SiN, or the like. The mask 2 can be formed by using a photolithography technique and an etching technique.

The mask 2 may have a pattern in which a plurality of linear portions 2a extending in a first direction (depth direction in FIG. 9) are periodically disposed in a second direction (left-right direction in FIG. 9) intersecting the first direction. A pitch of the plurality of linear portions 2a in the second direction may be, for example, 30 µm to 300 µm or 150 µm to 250 µm.

### (Growing Process)

In the growing process S13, for example, as illustrated in FIG. 10, the semiconductor element layer 3, which is a precursor of the plurality of laminate bodies 10, is vapor-phase grown from the growth region 1a1 of the underlying substrate 1 onto the linear portions 2a of the mask 2 by using an ELO method. In the growing process S13, for example, a vapor phase growth method such as: a hydride vapor phase epitaxy (HVPE) method using a chloride as a group III (group 13 element) raw material; a metal organic chemical vapor deposition (MOCVD) method using an organic metal as a group III raw material; or a molecular beam epitaxy (MBE) method can be used.

Since the semiconductor element layer 3 formed on the mask 2 by the ELO method does not take over through transition in the semiconductor element layer 3 at a mask opening portion, the semiconductor element layer 3 has crystallinity with high quality. According to the ELO method, even when a different kind of substrate such as sapphire or Si is used, a semiconductor element layer with high quality can be obtained.

When the semiconductor element layer 3 is grown by an MOCVD method, the underlying substrate 1 on which the mask 2 is formed is first inserted into a reaction chamber of a vapor phase growth apparatus, and the underlying substrate 1 is heated to a predetermined temperature (for example, 1050 to 1100°C) with the chamber supplied with hydrogen gas, nitrogen gas, or a mixed gas of hydrogen and nitrogen and a group V raw material (containing a group 15 element) gas such as ammonia.

After the temperature of the underlying substrate 1 is stabilized, in addition to the mixed gas and the group V raw material gas, which have been described above, a raw material containing a group III (group 13 element) raw material such as trimethylgallium (TMG) is supplied to perform vapor phase growth of the semiconductor element layer 3 from the growth region 1a1. At this time, by supplying the raw material gas containing an n-type or p-type impurity and adjusting a doping amount of the impurity, the semiconductor element layer 3 of a desired electrical conductivity type can be obtained. By appropriately selecting the impurity to be added to the raw material gas and appropriately adjusting the doping amount of the impurity, the semiconductor element layer 3 can be formed by layering the plurality of semiconductor layers 11, 12, and 13.

In the process of growing the semiconductor element layer 3, a fragile layer (also referred to as a sacrificial layer) may be formed at a portion of the semiconductor element layer 3 positioned in a groove 2b. By forming the fragile layer, when an external force is applied to the semiconductor element layer 3, stress is concentrated on the fragile layer and cracks are easily generated, which easily separates the semiconductor element layer 3 from the underlying substrate 1 in the transferring process S14.

As the fragile layer, for example, a layer made of a mixed crystal of GaN and BN, AlN, InN or the like may be formed. A GaN-based semiconductor layer having a lattice constant different from that of the semiconductor element layer 3 may be formed as the fragile layer. A fragile layer having a superlattice structure may be formed by alternately layering AlGaN layers and GaN layers. The fragile layer may be a layer obtained by periodically changing growth conditions of the semiconductor element layer and alternately layering layers having large crystal grains and layers having small crystal grains. The fragile layer may be formed by irradiating a portion of the semiconductor element layer 3 positioned in the groove 2b with a laser beam after the growth of the semiconductor element layer 3 is finished, and changing a crystalline structure of the portion by thermal denaturation.

After the crystal growth surface exceeds the upper edge of the groove 2b, the semiconductor element layer 3 grows in the lateral direction (the second direction) along the upper surfaces of the linear portions 2a. The growth of the semiconductor element layers 3 in the lateral direction is stopped before the semiconductor element layers 3 growing with the adjacent growth regions 1a1 serving as start points come into contact with each other. This can suppress the fact that the semiconductor element layers 3 come into contact with each other, and crystal defects such as cracks or through transition are easily generated at a portion where the semiconductor element layers 3 come into contact with each other.

After the growth of the semiconductor element layer 3 is stopped, the underlying substrate 1 is taken out from the vapor phase growth apparatus, and the mask 2 is removed by etching. This etching is carried out by using an etchant that does not substantially erode the grown semiconductor element layer 3. By removing the mask 2, for example, as illustrated in FIG. 11, the plurality of semiconductor element layers 3 connected to the underlying substrate 1 by connecting portions 3a can be obtained.

Before or after the mask 2 is removed, a ridge waveguide, an electrode, and an insulating film may be formed at the semiconductor element layer 3, and the semiconductor element layer 3 may be used as a precursor of the laminate body 10 having the single-sided electrode structure (see FIG. 3A). Although the case where the semiconductor element layer 3 is the precursor of the laminate body 10 having the single-sided electrode structure will be described below, the semiconductor element layer 3 may be a precursor of the laminate body 10 having the double-sided electrode structure (see FIG. 3B).

The semiconductor element layer 3 may have a structure in which the first semiconductor layer 11, the active layer 12, and the second semiconductor layer 13 are layered in this order from the underlying substrate 1 side. In this case, the semiconductor element layer 3 is etched and the first semiconductor layer 11, the active layer 12, and the second semiconductor layer 13 are partially removed. Then, the n-type electrode, the p-type electrode, and the insulating film are formed, thereby obtaining the precursor of the laminate body 10 having the single-sided electrode structure illustrated in FIG. 3A, for example.

### (Transferring Process)

In the transferring process S14, the plurality of semiconductor element layers 3 obtained in the growing process S13 are transferred to the first support substrate 4. The first support substrate 4 may be made of an insulating material or a semi-insulating material, or may be made of an electrically conductive material. Examples of the insulating material or the semi-insulating material to be used for the first support substrate 4 include Si, SiC, and AlN. When the first support substrate 4 is used as a submount, the thermal conductivity of the submount can be increased by producing the first support substrate 4 from a material such as Si, SiC, or AlN, and thus, the semiconductor device having excellent heat dissipation properties can be manufactured. When the first support substrate 4 is made of Si, the first support substrate 4 can be a substrate having a large diameter at low cost with excellent in workability, which can reduce the manufacturing cost of the semiconductor device. Examples of the electrically conductive material to be used for the first support substrate 4 include metal materials containing Cu, Al, and the like.

For example, as illustrated in FIG. 12, a plurality of recessed portions 41 are formed in the first support substrate 4. The plurality of recessed portions 41 is opened on one main surface 4a of the first support substrate 4, and are recessed in the thickness direction of the first support substrate 4. The plurality of recessed portions 41 is arrayed in a matrix in a third direction (an up-down direction in FIG. 12) and a fourth direction (the left-right direction in FIG. 12) intersecting the third direction when viewed in a direction orthogonal to the one main surface 4a. An opening shape of each of the plurality of recessed portions 41 may be a rectangular shape, a square shape, a hexagonal shape, or the like, or may be another shape. A pitch of the recessed portions 41 in the fourth direction may be substantially a natural number multiple of a pitch of the semiconductor element layers 3 in the second direction. The plurality of recessed portions 41 can be formed by using an etching technique. The etching may be dry etching or wet etching.

For example, as illustrated in FIG. 12, the first support substrate 4 includes a plurality of wall portions 42 that separate the adjacent recessed portions 41 to each other in the third direction.

For example, as illustrated in FIG. 12, a plurality of wirings 44 are routed on the one main surface 4a of the first support substrate 4. The plurality of wirings 44 includes a plurality of bonding members 44a and 44b. When the first support substrate 4 is cut and the plurality of first support bodies 20 are produced, the plurality of wirings 44 become the plurality of wirings 24 routed on the upper surface 20a of the first support body 20. When the first support substrate 4 is made of an electrically conductive material, an insulating layer may be disposed on the one main surface 4a of the first support substrate 4, and the plurality of wirings 44 may be disposed on the insulating layer. As a result, a short circuit between the wirings 44 can be suppressed, which can cause the semiconductor device to normally operate.

The wiring 44 may include a metal layer made of, for example, Au, Ti, Ni, or the like. The wiring 44 may be constituted by a single metal layer or may be constituted by multiple metal layers. When the wiring 44 is constituted by multiple metal layers, the outermost surface may be a metal layer made of Au. This can suppress corrosion of the wiring 44. When the wirings 44 are bonded to the n-type and p-type electrodes of the semiconductor element layer 3 through the bonding members 44a and 44b, respectively, the bonding performance between the wiring 44 and the bonding members 44a and 44b can be improved. The bonding members 44a and 44b are electrically conductive bonding members such as solder. The bonding members 44a and 44b may be solder such as AuSi or AuSn, for example. Without providing the bonding members 44a and 44b, the n-type electrode and the p-type electrode of the semiconductor element layer 3 may be bonded to the wirings 44 by using metal-metal bonding such as Au-Au bonding, surface-activation bonding, or the like.

In the transferring process S14, the one main surface 1a of the underlying substrate 1 and the one main surface 4a of the first support substrate 4 are caused to oppose each other, and the second direction in which the plurality of semiconductor element layers 3 is aligned and the fourth direction in which the plurality of recessed portions 41 is aligned are caused to coincide with each other. For example, as illustrated in FIG. 13, the n-type electrode and the p-type electrode of the semiconductor element layer 3 connected to the underlying substrate 1 are respectively bonded to the bonding member 44a and the bonding member 44b that are disposed on the one main surface 4a of the first support substrate 4 by using an electrically conductive bonding member such as solder. After this, for example, as illustrated in FIG. 14, the external force is applied in a manner that the semiconductor element layer 3 integrated with the first support substrate 4 is peeled off from the underlying substrate 1, and the semiconductor element layer 3 is pulled up from the one main surface 1a of the underlying substrate 1. Thus, for example, as illustrated in FIG. 15, the semiconductor element layer 3 can be transferred to the first support substrate 4.

When the semiconductor element layer 3 is produced by using the ELO method, for example, as illustrated in FIG. 11, the semiconductor element layer 3 connected to the underlying substrate 1 only with the connecting portion 3a interposed therebetween can be obtained. As a result, the transferring process S14 can be easily performed, and the manufacturing yield of the semiconductor device can be improved.

In the manufacturing method for the semiconductor device according to the present embodiment, the semiconductor element layer 3 is peeled off from the underlying substrate 1, and thus, can have a thickness of 5 to 30 µm. Thus, in the subsequent cleaving process S15, the semiconductor element layer 3 can be cleaved into a plurality of pieces of the semiconductor element layer 3 each of which has a short resonator length. When the semiconductor element layer 3 is peeled off from the underlying substrate 1 before performing the cleaving process S15, the semiconductor element layer 3 can be easily cleaved.

Note that when a part of the underlying substrate 1 remains on the semiconductor element layer 3 after the semiconductor element layer 3 is peeled off from the underlying substrate 1, the following problem may occur. First, when a material system of the semiconductor element layer 3 and a material system of the underlying substrate 1 are different from each other, since a crystal system of the semiconductor element layer 3 and a crystal system of the underlying substrate 1 are different from each other, the cleavage of the semiconductor element layer 3 may be difficult due to a part of the underlying substrate 1 remaining. Even when the material system of the semiconductor element layer 3 and the material system of the underlying substrate 1 are the same, when the underlying substrate 1 includes many defects, the defects may become abnormal portions, which may deteriorate the quality of the cleavage of the semiconductor element layer 3. The residue of the underlying substrate 1 can be removed by a known method such as mechanical polishing or etching. When the residue of the underlying substrate 1 is sufficiently thin, the residue does not need to be removed.

The pitch of the plurality of semiconductor element layers 3 formed on the underlying substrate 1 in the second direction does not coincide with the pitch of the plurality of recessed portions 41 formed in the first support substrate 4 in the fourth direction in some cases. For example, when the pitch of the semiconductor element layers 3 in the second direction is smaller than the pitch of the recessed portions 41 in the fourth direction, the plurality of semiconductor element layers 3 may be transferred to the first support substrate 4 every other row or every plurality of rows in the transferring process S14. The semiconductor element layer 3 that is not transferred to the first support substrate 4 and that remains on the underlying substrate 1 may be transferred to another first support substrate 4.

### (Cleaving Process)

The cleaving process S15 is a process of cleaving the semiconductor element layer 3 transferred to the first support substrate 4 and thereby forming the laminate body 10 including exposed resonator surfaces (exposed end surfaces). In the cleaving process S15, first, a scribed scratch to be cleaved is formed at the semiconductor element layer 3, and then, the semiconductor element layer 3 is broken (fractured) into a plurality of pieces of the semiconductor element layer 3. Thereafter, by removing the pieces of the semiconductor element layer 3 that are not fixed to the wirings 44, for example, as illustrated in FIG. 16, the plurality of laminate bodies 10 each of which is disposed on a respective one of the plurality of wall portions 42 of the first support substrate 4 is obtained. In each of the plurality of laminate bodies 10, the first resonator surface 10a and the second resonator surface 10b are exposed. Note that the first resonator surface 10a and the second resonator surface 10b do not need to be cleavage surfaces formed by the cleaving. At least one of the first resonator surface 10a and the second resonator surface 10b may be an etched mirror surface formed by etching. Note that in the present embodiment, in an opening width of the recessed portion 41, a length in the first direction is larger than a length in the second direction, but the length in the first direction may be smaller than the length in the second direction.

Note that the cleaving process S15 may be a process of cleaving the semiconductor element layer 3 before the transferring to the first support substrate 4 and thereby forming the laminate body 10 including the exposed resonator surfaces (end surfaces).

### (Cutting Process)

The cutting process S16 is a process of cutting the first support substrate 4 and thereby producing a plurality of first support bodies 20 each of which is provided with a plurality of laminate bodies 10. In the cutting process S16, the first support substrate 4 disposed with the plurality of laminate bodies 10 is cut along the fourth direction (the left-right direction in FIG. 16), for example, in a region positioned between the wall portions 42 adjacent to each other in a plan view. Thus, the plurality of first support bodies 20 (see FIG. 17) each of which is disposed with the plurality of laminate bodies 10 can be produced.

Although an example in which the semiconductor element layer 3 is transferred from the underlying substrate 1 to the first support substrate 4 has been described above, the semiconductor element layer 3 may be transferred from the underlying substrate 1 to a holding member and then transferred from the holding member to the first support substrate 4. The holding member may be, for example, a plate-shaped member in which a bonding layer made of AuSn, AuGe, NiSn or the like is disposed on the one main surface 4a, or may be a dicing tape in which an adhesive layer made of an adhesive is disposed on the one main surface 4a of the base member made of resin. When the holding member is the dicing tape, in transferring the semiconductor element layer 3 from the holding member to the first support substrate, the dicing tape can be extended and the pitch of the plurality of semiconductor element layers 3 held by the dicing tape can be caused to substantially coincide with the pitch of the plurality of recessed portions 41.

The above-described manufacturing method for the semiconductor device including the preparing process S11, the mask forming process S12, the growing process S13, the transferring process S14, the cleaving process S15, and the cutting process S16 can further improve the manufacturing efficiency of the semiconductor device. The manufacturing method for the semiconductor device described above is particularly effective when the size of the laminate body 10 is so small that the laminate body 10 cannot be individually handled.

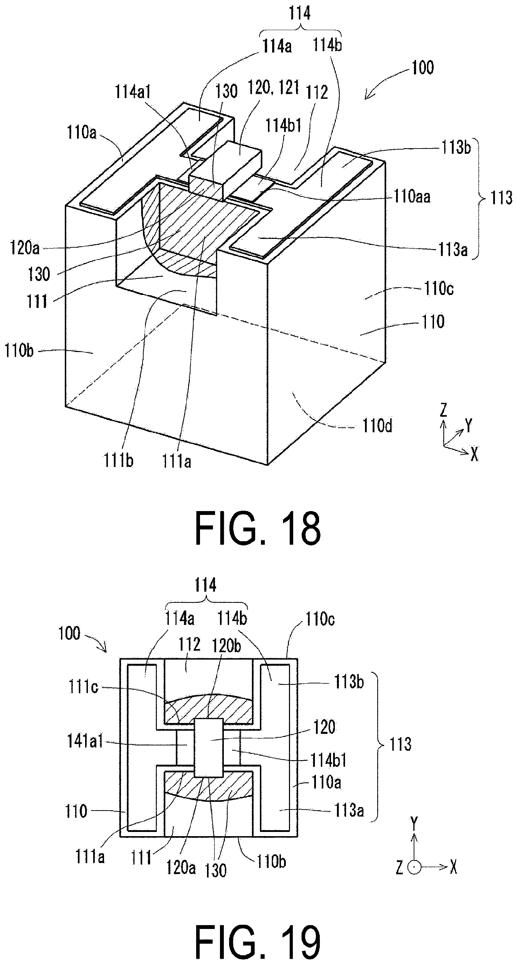

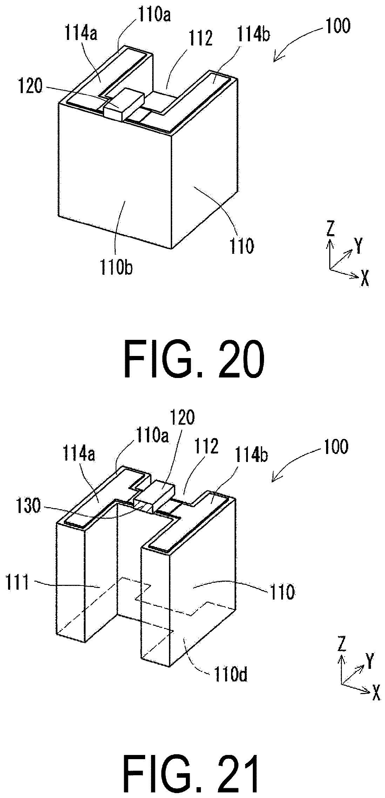

A semiconductor device according to the embodiment of the present disclosure will be described. FIG. 18 is a perspective view schematically illustrating the semiconductor device according to an embodiment of the present disclosure, and FIG. 19 is a plan view schematically illustrating the semiconductor device according to the embodiment of the present disclosure. FIGs. 20 to 27 are perspective views schematically illustrating variations of the semiconductor device according to the embodiment of the present disclosure.

The semiconductor device 100 according to the present embodiment includes a substrate 110, a laminate body 120, and a dielectric layer 130.

The substrate 110 may be made of an insulating material or a semi-insulating material, or may be made of an electrically conductive material. Examples of the insulating material or the semi-insulating material to be used for the substrate 110 include Si, SiC, and AlN. Examples of the electrically conductive material to be used for the first support substrate 4 include metal materials containing Cu, Al, and the like. A shape of the substrate 110 may be, for example, a rectangular parallelepiped shape, a cubic shape, or any other shape. In the present embodiment, for example, as illustrated in FIG. 20, the substrate 110 has a substantially rectangular parallelepiped shape.

The substrate 110 includes an upper surface 110a, a side surface (also referred to as a first side surface) 110b continuous with the upper surface 110a, a second side surface 110c on an opposite side to the first side surface 110b, and a lower surface 110d on an opposite side to the upper surface 110a. The substrate 110 includes a recessed portion (also referred to as a first recessed portion) 111 that is opened to the upper surface 110a and the first side surface 110b. The substrate 110 may further include a recessed portion (also referred to as a second recessed portion) 112 that is opened to the upper surface 110a and the second side surface 110c.

For example, as illustrated in FIG. 18, the substrate 110 may include a wiring 114 disposed on the upper surface 110a. The wiring 114 may include a first wiring 114a and a second wiring 114b. The first wiring 114a and the second wiring 114b may be separated from each other and then disposed. The first wiring 114a may include a bonding member 114a1 electrically connected to an n-type electrode of the laminate body 120. The second wiring 114b may include a bonding member 114b1 electrically connected to a p-type electrode of the laminate body 120. When the substrate 110 is made of an electrically conductive material, an insulating layer may be disposed on the upper surface 110a of the substrate 110, and the wiring 114 may be disposed on the insulating layer. This can suppress a short circuit between the wirings 114, which can cause the semiconductor device to normally operate.

The wiring 114 may include a metal layer made of, for example, Au, Ti, Ni, or the like. The wiring 114 may be made of a single metal layer or may be made of multiple metal layers. When the wiring 114 is made of multiple metal layers, the outermost surface may be a metal layer made of Au. This can suppress corrosion of the wiring 114. The bonding members 114a1 and 114b1 are electrically conductive bonding members such as solder. The bonding members 114a1 and 114b1 may be made of solder such as AuSi or AuSn, for example. Without providing the bonding members 114a1 and 114b1, the n-type electrode and the p-type electrode of the laminate body 10 may be bonded to the first wiring 114a and the second wiring 114b, respectively, by using metal-metal bonding such as Au-Au bonding, surface-activation bonding, or the like.

The laminate body 120 is an LD element including a first resonator surface (also referred to as a first end surface) 120a and a second resonator surface (also referred to as a second end surface) 120b opposed to the first resonator surface 120a.
The laminate body 120 may be a GaN-based nitride semiconductor LD element. The first resonator surface 120a may be a light emission surface of the laminate body 120. The second resonator surface 120b may be a light reflection surface of the laminate body 120. At least one of the first resonator surface 120a and the second resonator surface 120b may be a cleavage surface formed by cleaving. The laminate body 120 is disposed on the upper surface 110a of the substrate 110. The laminate body 120 may be disposed in a mounting region 110aa having a stripe shape on the upper surface 110a, the mounting region 110aa being narrowed by forming the recessed portions 111 and 112. The laminate body 120 may be disposed in a manner that the first resonator surface 120a is positioned above the first recessed portion 111 when viewed from the direction orthogonal to the first side surface 110b (the Y direction in FIG. 18). In the laminate body 120, the first resonator surface 120a may be positioned above the first recessed portion 111, and the second resonator surface 120b may be positioned above the second recessed portion 112. In the laminate body 120, the first resonator surface 120a may be positioned on the mounting region 110aa as long as the upper surface 110a does not block light emitted from the first resonator surface 120a.

The laminate body 120 may include a body 121 including a plurality of semiconductor layers, as illustrated in FIG. 2. The body 121 may have a lower surface opposing the upper surface 110a of the substrate 110 and an upper surface on the opposite side to the lower surface. The laminate body 120 may be a laminate body having a single-sided electrode structure as illustrated in FIG. 3A, or may be a laminate body having a double-sided electrode structure as illustrated in FIG. 3B.
When the laminate body 120 is a laminate body having a double-sided electrode structure, the laminate body 120 includes a first electrode (also referred to as an n-type electrode) disposed on a lower surface, a second electrode (also referred to as a p-type electrode) disposed on an upper surface, and a wiring electrode (also referred to as a routing wiring) that routes the second electrode to a portion below the laminate body. The first electrode is connected to the first wiring 114a of the wiring 114. The second electrode is connected to the second wiring 114b of the wiring 114 through the routing wiring. When the semiconductor device 100 is mounted on a semiconductor package such as a TO-CAN type package, the first wiring 114a and the second wiring 114b may be individually connected to two terminal pins of the semiconductor package through connection members such as bonding wires.

For example, in the semiconductor device 100 according to the present embodiment, as illustrated in FIGs. 18 and 19, the wiring 114 is provided not only in the mounting region 110aa but also on the entire upper surface 1 10a. Thus, even when the size of the laminate body 120 is small and a bonding wire cannot be directly connected to the laminate body 120, a drive current can be supplied to the laminate body 120 by electrically connecting the wiring 114 and a terminal of a package or the like. The wiring 114 may be used as an inspection pad with which a probe terminal is brought into contact when probe measurement is performed.

The dielectric layer 130 is disposed on at least one of the first resonator surface 120a and the second resonator surface 120b of the laminate body 120 and on the side surface 111a of the recessed portion 111. FIG. 18 illustrates an example in which the dielectric layer 130 is disposed on the first resonator surface 120a for ease of illustration. The dielectric layer 130 may be formed on only a part of the side surface 111a, or may be formed on the entire side surface 111a. The dielectric layer 130 is made of a dielectric material such as SiO₂, Al₂O₃, AlN, AlON, Nb₂O₅, TazOs, or ZrO₂. The dielectric layer 130 may be a multilayer film made of any of these dielectric materials. Note that, for example, as illustrated in FIG. 18, the side surface 111a of the recessed portion 111 refers to a surface substantially parallel to the first side surface 110b of the substrate 110 among the side surfaces of the recessed portion 111.

In the semiconductor device 100, the dielectric layer 130 is disposed on at least one of the first resonator surface 120a and the second resonator surface 120b. When the dielectric layer 130 is disposed on the first resonator surface 10a (light emission surface), optical damage to the end surface can be suppressed, which can cause the semiconductor device to have excellent reliability. When the dielectric layer 130 is disposed on the second resonator surface 10b (light reflection surface), the reflection efficiency at the second resonator surface 10b can be increased, and the semiconductor device can have excellent light emission efficiency and reliability.

In the semiconductor device 100, since the side surface 111a is on substantially the same plane as that of the first resonator surface 120a, the dielectric layer 130 having substantially the same configuration as that of the dielectric layer 130 formed on the first resonator surface 120a is formed on the side surface 111a. In the semiconductor device 100, by analyzing the dielectric layer 130 formed on the side surface 111a, a state (a reflectance, an index of refraction, a film thickness, or the like) of the dielectric layer 130 formed on the first resonator surface 120a can be known, which causes manufacturing for the semiconductor device 100 to be easily controlled.

The dielectric layer 130 may be further formed on at least a partial region of each of the bonding members 114a1 and 114b1. This can suppress deterioration, alteration, peeling, and the like of the bonding members 114a1 and 114b1.

The dielectric layer 130 may be further disposed on at least one of the first side surface 110b and the second side surface 110c of the substrate 110. Since the dielectric layer 130 is formed in a wide range on the surface of the substrate 110, the state of the dielectric layer 130 can be easily visually distinguished.

The dielectric layer 130 may be further disposed on a bottom surface 111b of the recessed portion 111. The bottom surface 11 1b of the recessed portion 111 refers to a surface that is continuous with the side surface 111a of the recessed portion 111 and that is substantially parallel to the upper surface 110a of the substrate 110.

In the semiconductor device 100, an area of the bottom surface 111b of the recessed portion 111 may be smaller than an area of the side surface 111a of the recessed portion 111. This can suppress blocking of light emitted from the laminate body 120 at the bottom surface 111b, and thus, the semiconductor device in which extraction efficiency of light is improved can be obtained.

In the semiconductor device 100, the first resonator surface 120a of the laminate body 120 may be positioned on the opening of the first recessed portion 111. This makes it possible to suppress blocking of light emitted from the first resonator surface 120a of the laminate body 120 at the substrate 110. Thus, the semiconductor device in which the extraction efficiency of light is improved can be obtained. Note that the first resonator surface 120a may be positioned on the upper surface 110a of the substrate 110 or may be on the same plane as the side surface of the first recessed portion 111.

In the semiconductor device 100, the second resonator surface 120b of the laminate body 120 may be positioned on the opening of the second recessed portion 112. In this case, a photodiode which detects light leaking from the second resonator surface 120b can be disposed in the second recessed portion 112. As a result, a drive current to be supplied to the laminate body 120 can be controlled based on a detection result of the photodiode, which can improve the reliability of the semiconductor device 100.

The bottom surface of the second recessed portion 112 may be positioned outside an irradiation region of the second resonator surface 120b. This makes it easy to dispose the photodiode which detects light leaking from the second resonator surface 120b on the bottom surface of the second recessed portion 112.

For example, as illustrated in FIGs. 18 and 19, the substrate 110 may include a protruding portion 113 protruding outward relative to the side surface 111a of the recessed portion 111. The wiring 114 may be disposed on the upper surface of the protruding portion 113. The protruding portion 113 may include a first protruding portion 113a protruding toward the first resonator surface 120a side and a second protruding portion 113b protruding toward the second resonator surface 120b side. Regarding the first protruding portion 113a and the second protruding portion 113b, in a direction orthogonal to the side surface 111a, a length of the first protruding portion 113a may be longer than a length of the second protruding portion 113b, and the length of the second protruding portion 113b may be longer than the length of the first protruding portion 113a. In the semiconductor device 100 illustrated in FIG. 18, the wiring 114 disposed on the upper surface of one of the first protruding portion 113a and the second protruding portion 113b can be used as a wiring for an aging test of the laminate body 120, and the wiring 114 disposed on the upper surface of the other one of the first protruding portion 113a and the second protruding portion 113b can be used as a wiring for driving the laminate body 120. This makes it possible to reduce the possibility of damaging the wiring for driving the laminate body 120 when the aging test of the laminate body 120 is performed, which makes it possible to improve the reliability of the semiconductor device 100. Since the substrate 110 includes the protruding portion 113, even when a bonding wire cannot be directly connected to the laminate body 120, a drive current can be supplied to the laminate body 120.

For example, as illustrated in FIG. 20, the upper surface 110a of the substrate 110 may have a substantially U-shape when viewed in a direction orthogonal to the upper surface 110a. In the semiconductor device 100 illustrated in FIG. 20, only the second recessed portion 112 is provided, and a region of the upper surface 110a of the substrate 110 where the laminate body 120 is disposed is continuous with the first side surface 110b of the substrate 110. Thus, when the semiconductor device 100 is used in combination with an optical member including a waveguide, a light emitting point of the laminate body 120 and an incident surface of the waveguide can be brought close to each other, and loss of light can be suppressed.
An optical detector such as a photodiode can be easily disposed in the second recessed portion 112.

For example, as illustrated in FIGs. 18, 19, and 21, the upper surface 110a of the substrate 110 may have a substantially H-shape when viewed in the direction orthogonal to the upper surface 110a. For example, as illustrated in FIG. 21, the semiconductor device 100 may include the first recessed portion 111 and the second recessed portion 112 that are cut from the upper surface 110a to the lower surface 110d. According to the semiconductor device 100 illustrated in FIG. 21, the extraction efficiency of light of the semiconductor device 100 can be further improved. In the manufacturing process of the semiconductor device 100, when the dielectric layer 130 is formed while the laminate body 120 is disposed on the substrate 110, the bottom surface of the first recessed portion 111 and the bottom surface of the second recessed portion 112 that interfere with film formation of the dielectric layer 130 are not present, which can excellently form the dielectric layer 130. This makes it possible to suppress blocking of light emitted from the laminate body 120 at the substrate 110.

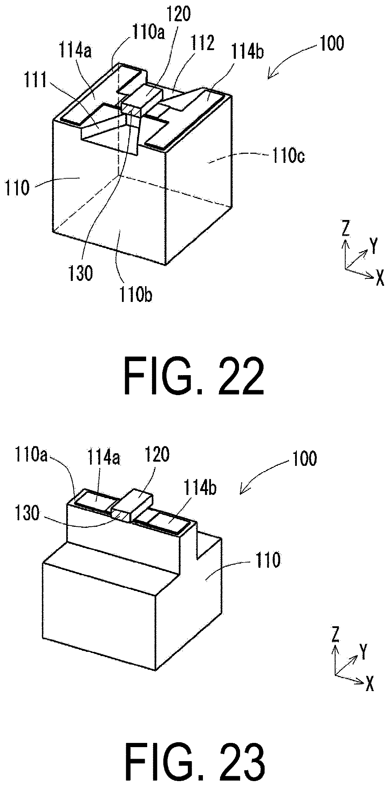

For example, as illustrated in FIG. 22, the semiconductor device 100 may have a configuration in which the first recessed portion 111 is spread in a tapered manner toward the first side surface 110b, and the second recessed portion 112 is spread in a tapered manner toward the second side surface 110c. According to the semiconductor device 100 illustrated in FIG. 22, the extraction efficiency of light can be improved, and the dielectric layer 130 can be excellently formed. Since an area of the upper surface 110a of the substrate 110 is increased, the wiring 114 can be easily disposed. Since mechanical strength of the substrate 110 can be improved, the reliability of the semiconductor device 100 can be improved.

For example, as illustrated in FIG. 23, the upper surface 110a of the substrate 110 may have a substantially I-shape when viewed in the direction orthogonal to the upper surface 110a. According to the semiconductor device 100 illustrated in FIG. 23, since the manufacturing process can be simplified, the manufacturing efficiency of the semiconductor device can be improved.

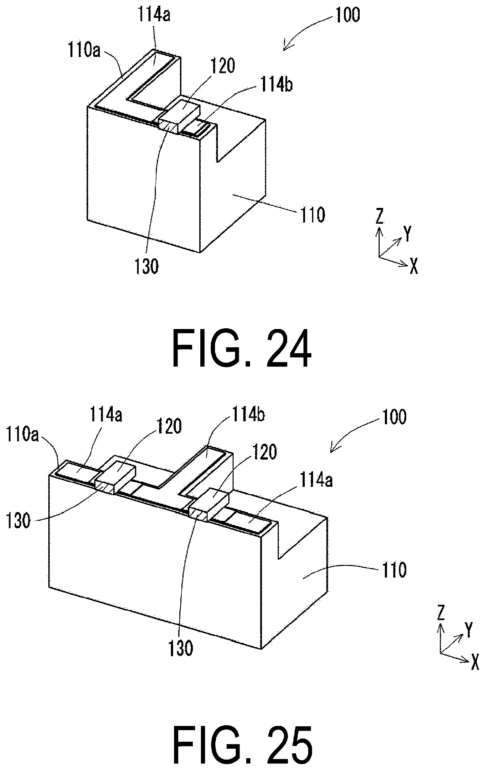

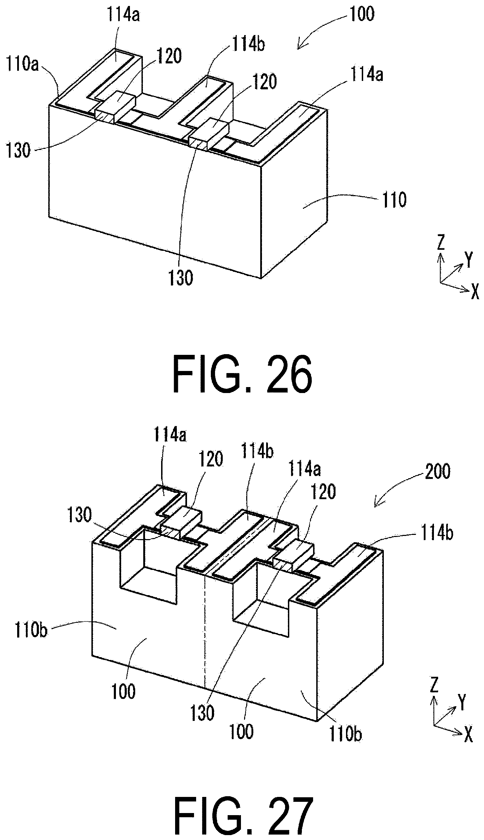

The upper surface 110a of the substrate 110 may have a substantially L-shape, for example, as illustrated in FIG. 24, a substantially T-shape, for example, as illustrated in FIG. 25, or a substantially E-shape, for example, as illustrated in FIG. 26, when viewed in the direction orthogonal to the upper surface 110a.

For example, as illustrated in FIG. 27, the plurality of semiconductor devices 100 may be combined, and thus may produce a composite semiconductor device 200. The composite semiconductor device 200 may be produced by combining the plurality of semiconductor devices 100. The composite semiconductor device 200 may be produced by dividing the first support body 20 in a manner that one piece of the first support body 20 includes the plurality of laminate bodies 10, in the dividing process S4. In this case, the alignment accuracy of the plurality of semiconductor devices 100 in the composite semiconductor device 200 can be increased, which is advantageous when the composite semiconductor device 200 is combined with another optical member.

In the semiconductor device 100 illustrated in FIGs. 18 to 27, the laminate body 120 is mounted on the mounting region 1 10aa of the upper surface 110a of the substrate 110, the mounting region 110aa having a width narrower than a distance between the first side surface 110b and the second side surface 110c due to formation of the recessed portions 111 and 112. A length of the mounting region 110aa in a resonance direction of the laminate body 120 (the Y direction in FIG. 18) is substantially equal to a resonator length of the laminate body 120 defined by a distance between the first resonator surface 120a and the second resonator surface 120b. Here, the fact that the length of the mounting region 110aa is substantially equal to the resonator length means that the length of the mounting region 110aa is within ±20% with respect to the resonator length. For example, when the resonator length is 100 µm, the length of the mounting region 110aa may be 80 to 120 µm. The length of the mounting region 110aa may be within ±10% with respect to the resonator length.

In the semiconductor device 100 illustrated in FIGs. 18 to 27, the first resonator surface 120a is positioned on substantially the same plane as the side surface 111a of the substrate 110 being continuous with the mounting region 110aa, and the second resonator surface 120b is positioned on substantially the same plane as the side surface 111c of the substrate 110 being continuous with the mounting region 1 10aa. Here, the fact that the first resonator surface 120a is positioned on substantially the same plane as the side surface 111a means that a distance between the first resonator surface 120a and the side surface 111a is within ±20% with respect to the resonator length. The fact that the second resonator surface 120b is positioned on substantially the same plane as the side surface 111c means that a distance between the second resonator surface 120b and the side surface 111c is within ±20% with respect to the resonator length. The distance between the first resonator surface 120a and the side surface 111a and the distance between the second resonator surface 120b and the side surface 111c may be within ±10% with respect to the resonator length. The semiconductor device 100 may have a configuration in which the first resonator surface 120a protrudes from the side surface 111a, and the second resonator surface 120b protrudes from the side surface 111c. However, when the laminate body 120 is not in contact with the substrate 110, heat dissipation is deteriorated, and thus, a protruding amount needs to be within a predetermined range. The semiconductor device 100 may have a configuration in which the first resonator surface 120a and the second resonator surface 120b are positioned on the mounting region 110aa. In other words, the semiconductor device 100 may have a configuration in which the first resonator surface 120a is at a position recessed from the side surface 111a, and the second resonator surface 120b is at a position recessed from the side surface 111c. The first resonator surface 120a may be recessed from the side surface 111a as long as the upper surface 110a does not block light emitted from the first resonator surface 120a.

The semiconductor device 100 can be manufactured by using the manufacturing method for the semiconductor device described above. The semiconductor device 100 can be efficiently manufactured by dividing the first support body 20 (see FIGs. 4A, 4B, and 17) on which the plurality of laminate bodies 10 is disposed.

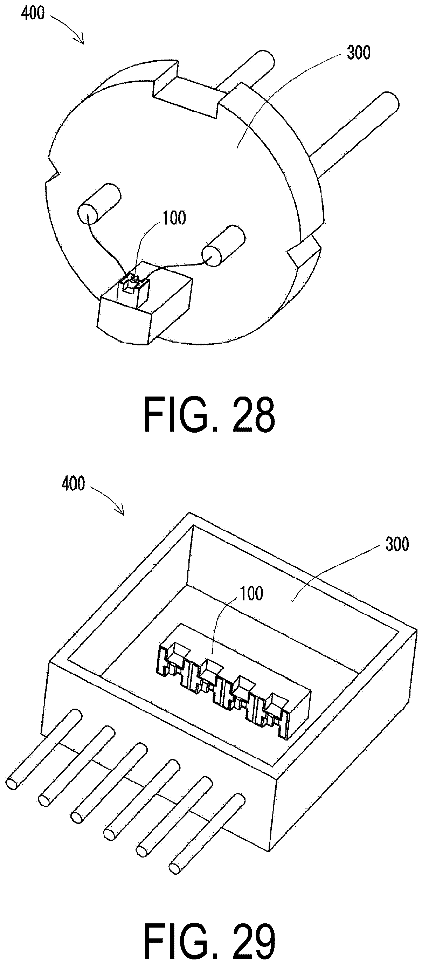

A semiconductor apparatus according to the embodiment of the present disclosure will be described. FIG. 28 is a perspective view schematically illustrating an example of the semiconductor apparatus according to the embodiment of the present disclosure, and FIG. 29 is a perspective view schematically illustrating another example of the semiconductor apparatus according to the embodiment of the present disclosure. Note that in FIG. 29, connection conductors, which connect the semiconductor device and the terminals of the package, are omitted for ease of illustration.

A semiconductor apparatus 400 according to the present embodiment includes the semiconductor device 100 and a package 300. The semiconductor devices 100 and 200 may be the semiconductor devices 100 illustrated in FIGs. 18 to 26. As the package 300, a known package can be used. The package 300 may be, for example, a TO-CAN type package as illustrated in FIG. 28. According to the semiconductor apparatus 400, since the first support body 20 used when the dielectric layer 130 is formed on each of the first end surfaces 11a, 12a, and 13a of the laminate body 10 also serves as a submount in the semiconductor apparatus 400, a process of individually die-bonding the plurality of laminate bodies 10 disposed on the first support body 20 is not required. As a result, a problem in miniaturizing the laminate body can be solved. The semiconductor device 100 can be mounted on various packages of a surface mounting type in addition to the TO-CAN type package.

In the semiconductor apparatus 400, for example, as illustrated in FIG. 29, the composite semiconductor device 200, that is, the arrayed semiconductor device 200 may be mounted on the package 300 of the surface mounting type. In the arrayed semiconductor device 200, a plurality of light emitting points of the plurality of laminate bodies 120 needs to be positioned with high accuracy. Thus, as the arrayed semiconductor device 200, a plurality of semiconductor elements (for example, a bar laser) connected in a bar shape is typically used. However, in the bar laser, since positions of the plurality of light emitting points are determined by design at a wafer level, a degree of freedom in design of an interval between adjacent light emitting points to each other is low. In the semiconductor apparatus 400 according to the present embodiment, since the plurality of laminate bodies 120 is individually separated, the interval between the adjacent light emitting points to each other can be controlled only by changing design of at least one of the first recessed portion 111 and the second recessed portion 112 in the substrate 110 and changing a position where the laminate body 120 is disposed. Thus, the semiconductor apparatus 400 has a high degree of freedom in design and can be widely applied to various applications. In the semiconductor apparatus 400, although the plurality of laminate bodies 120 is individually separated, the plurality of laminate bodies 120 is transferred and aligned on the first support body 20 with high positional accuracy. Thus, in the semiconductor apparatus 400, the plurality of light emitting points of the plurality of laminate bodies 120 is disposed with high accuracy.

In the semiconductor devices 100 and 200, the lower surface 110d of the substrate 110 may be connected to the mounting surface of the package 300, and the second side surface 110c of the substrate 110 may be connected to the mounting surface of the package 300. In the semiconductor apparatus 400, photodiodes may be disposed in the recessed portions 111 and 112 of the substrate 110. The photodiode may be configured to detect light emitted from the first resonator surface 120a, or may be configured to detect light leaking from the second resonator surface 120b. Thus, a drive current to be supplied to the laminate body 120 can be controlled based on the detection result of the photodiode, which can improve the reliability of the semiconductor apparatus 400. Disposing the photodiodes in the recessed portions 111 and 112 makes it possible to improve the monitoring accuracy by the photodiode. Blocking of light emitted from the first resonator surface 120a at the photodiode can be suppressed.

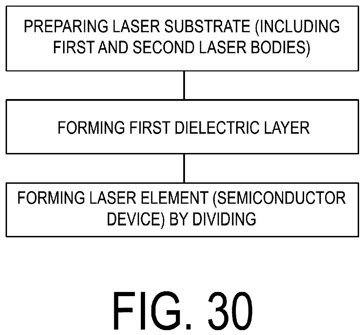

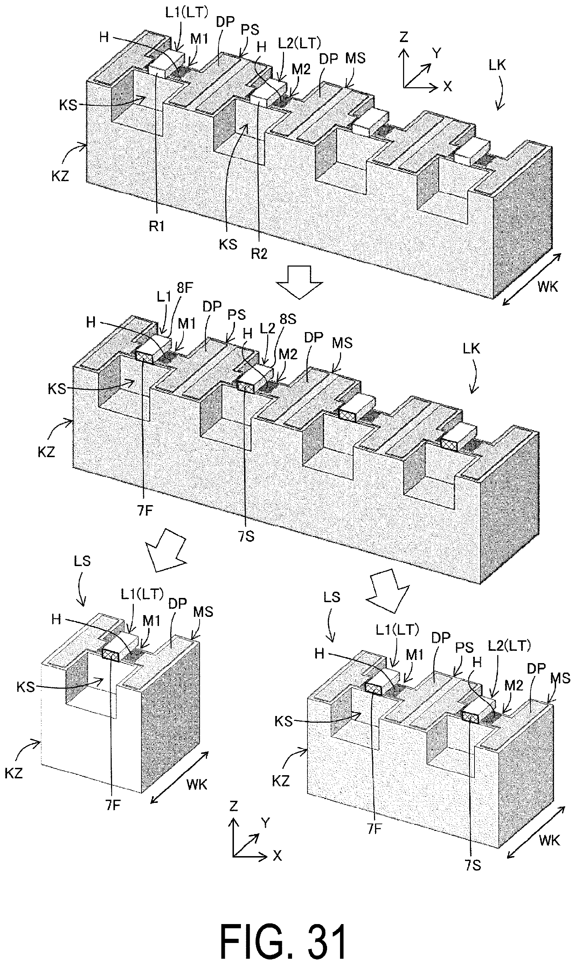

FIG. 30 is a flowchart illustrating the manufacturing method for the semiconductor device according to the present embodiment. FIG. 31 is a perspective view illustrating the manufacturing method for the semiconductor device according to the present embodiment. As illustrated in FIGs. 30 and 31, the manufacturing method for the semiconductor device according to the present embodiment includes preparing a laser substrate LK (including first and second laser bodies L1 and L2) and forming first and second dielectric layers F1 and F2. Thereafter, obtaining a laser element LS (semiconductor device) by dividing the laser substrate LK may be performed.

As illustrated in FIG. 31, the laser substrate LK includes a base member KZ including an upper surface including first and second regions M1 and M2, and first and second laser bodies L1 and L2 positioned above the base member KZ. The base member KZ has a longitudinal shape, widths (sizes in the Y direction) of the first and second regions M1 and M2 are smaller than a base member width WK, a resonator length of the first laser body L1 is larger than the width of the first region M1, and a resonator length of the second laser body L2 is larger than the width of the second region M2. The base member width WK may be the maximum width of the bottom surface of the base member KZ. The first laser body L 1 is disposed in a manner that a direction orthogonal to the resonator length direction of the first laser body and the width direction (the Y direction) of the first region M1 intersect with each other. The second laser body L2 is disposed in a manner that a direction orthogonal to the resonator length direction of the second laser body and the width direction (the Y direction) of the second region M2 intersect with each other. The resonator length direction of the first laser body L1 may be parallel to the width direction of the first region M1, and the resonator length direction of the second laser body L2 may be parallel to the width direction of the second region M2.

After preparing the laser substrate LK, forming a first dielectric layer 7F covering one end surface R1 of a pair of resonator end surfaces of the first laser body L1 and a first dielectric layer 7S covering one end surface R2 of a pair of resonator end surfaces of the second laser body L2 is performed. This is advantageous that both ease of handling of the laser substrate LK and appropriate formation of the first dielectric layers 7F and 7S (for example, reflector films) can be achieved. The resonator end surfaces R1 and R2 may be on the light reflection side (surfaces on the opposite side to emission surfaces for laser beams). After forming the first dielectric layers 7F and 7S, the laser substrate LK may be reversed, and then, form second dielectric layers 8F and 8S (for example, reflector films). Each of the first and second laser bodies L1 and L2 may include a nitride semiconductor layer (for example, a GaN-based semiconductor layer) including an optical resonator.

The upper surface of the base member KZ may include a wide region MS that is wider than the first region M1, and an electrically conductive pad DP (for example, a T-shape) may be formed from on the first region M1 onto the wide region MS. Each electrode (for example, an anode) included in the first and second laser bodies L1 and L2 may be bonded to a portion of the electrically conductive pad DP positioned on the first region M1 through an electrically conductive bonding layer H (for example, a solder layer). A portion of the electrically conductive pad DP positioned on the wide region MS can be used for wire bonding, for example.

The base member KZ includes a plurality of notch-shaped portions KS (for example, with rectangular parallelepiped shapes), and one of a pair of resonator end surfaces R1 of the first laser body L1 may protrude over one of the plurality of notch-shaped portions KS, or the other resonator end surface may protrude over the different notch-shaped portion KS. With this configuration, light emitted from the first laser body L1 is less likely to be blocked at the base member KZ.

The laser substrate LK may have a bar shape in which a size in the X direction is larger than sizes in the Y direction and the Z direction (thickness direction), and have a configuration (of a one-dimensional arrangement type) in which a plurality of laser bodies LT including the first and second laser bodies L1 and L2 is aligned in the longitudinal direction (a D2 direction) of the base member KZ and the number of rows of the laser bodies on the base member KZ is one.
A plurality of laser elements LS (semiconductor devices) each of which includes one or more laser bodies LT may be obtained by cutting the base member KZ in the short-side direction (a D1 direction) after forming the first dielectric layers 7F and 7S.

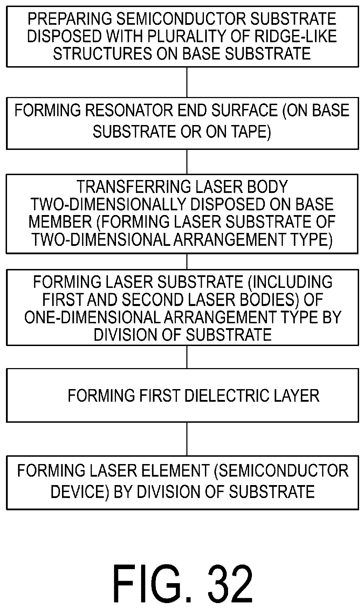

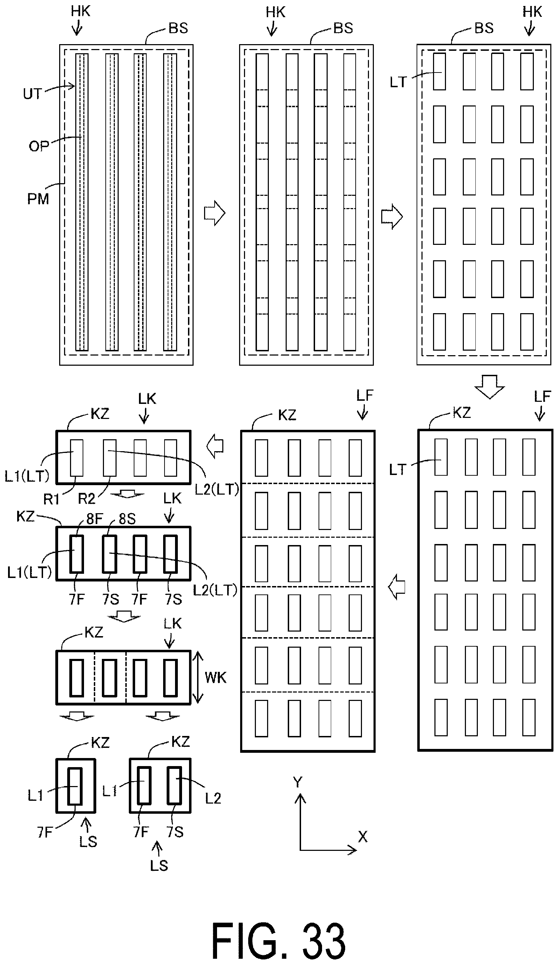

FIG. 32 is a flowchart illustrating the manufacturing method for the semiconductor device according to the present embodiment. FIG. 33 is a plan view illustrating the manufacturing method for the semiconductor device according to the present embodiment. As illustrated in FIGs. 32 and 33, preparing a semiconductor substrate HK where a plurality of ridge-like structures UT is disposed on a base substrate BS (substrate for crystal growth), each of the plurality of ridge-like structures UT including a nitride semiconductor layer, forming a resonator end surface (for example, an m surface of the nitride semiconductor layer) by division of each of the plurality of ridge-like structures UT, transferring laser bodies LT two-dimensionally disposed (from on the base substrate BS) onto a base member KZ (forming a laser substrate LF of a two-dimensional arrangement type), obtaining a laser substrate LK of a one-dimensional arrangement type (including first and second laser bodies L1 and L2) by division of the laser substrate LF of the two-dimensional arrangement type, forming first dielectric layers 7F and 7S (for example, reflector films) (in which forming second dielectric layers 8F and 8S by reversing the laser substrate LK may be applicable), and obtaining a laser element LS (semiconductor device) by division of the laser substrate LK (semiconductor device) of the one-dimensional arrangement type including the first dielectric layers 7F and 7S may be performed.

The division of the ridge-like structures UT may be performed on the base substrate BS, or on a tape (flexible substrate) to which the ridge-like structures UT are temporarily transferred. The division of the ridge-like structures UT may be performed by cleaving or etching.

In the semiconductor substrate HK, the ridge-like structures UT may be formed above a mask pattern PM (including a mask portion and slit-like opening portions OP) on the base substrate BS, and the ridge-like structure UT may stride over the opening portion OP extending in the D1 direction (the m-axis direction of the nitride semiconductor layer). The ridge-like structure UT may include at least one selected from the group consisting of GaN crystal, AlGaN crystal, InGaN crystal, and InAlGaN crystal. Forming a base portion (for example, GaN crystal) of the ridge-like structure UT by using an ELO method makes it possible to reduce through transition of a portion positioned on the mask portion.

The laser element LS (semiconductor device) illustrated in FIGs. 31 and 33 includes the base member KZ including the first region M1 having a width smaller than the base member width WK and the wide region MS having a width larger than the width of the first region M1 on an upper surface of the base member KZ, the first laser body L1 having a resonator length larger than the width of the first region M1, the first laser body L1 being disposed above the base member KZ, the first laser body L1 intersecting with (for example, being orthogonal to) the first region M1, and the first dielectric layer 7F covering one resonator end surface R1 of a pair of resonator end surfaces of the first laser body L1. The electrically conductive pad DP (for example, having a T-shape) may be formed from on the first region M1 onto the wide region MS. Each electrode (for example, an anode) included in the first and second laser bodies L1 and L2 may be bonded to a portion of the electrically conductive pad DP positioned on the first region M1 through an electrically conductive bonding layer H (for example, a solder layer).

In the laser element LS, the upper surface of the base member KZ may include the second region M2 having a width smaller than the base member width WK, be disposed with the second laser body L2 having a resonator length larger than the width of the second region M2 above the second region M2, the second laser body L2 intersecting with (for example, being orthogonal to) the second region M2, and be disposed with the first dielectric layer 7S, the first dielectric layer 7S covering one resonator end surface R2 of a pair of resonator end surfaces of the second laser body L2.

These are detailed descriptions of the embodiments of the present disclosure. However, the present disclosure is not limited to the embodiments described above, and various modifications or improvements or the like can be made without departing from the gist of the present disclosure.

### REFERENCE SIGNS

1 Underlying substrate
1a One main surface
1a1 Growth region
2 Mask
2a Linear portion
2b Groove
3 Semiconductor element layer
3a Connecting portion
4 First support substrate
4a One main surface
41 Recessed portion
42 Wall portion
44 wiring
44a N-type electrode pad
44b P-type electrode pad
10 Laminate body
10a First resonator surface
10b Second resonator surface
11 First semiconductor layer
11a First end surface
11b Second end surface
12 Active layer
12a First end surface
12b Second end surface
13 Second semiconductor layer
13a First end surface
13b Second end surface
14 First electrode (n-type electrode)
15 Second electrode (p-type electrode)
16 Ridge waveguide
17 First dielectric layer
18 Second dielectric layer
19 Insulating film
20 First support body
20a Upper surface
20aa Mounting region
20b First side surface
20c Second side surface
21 Recessed portion
21a First recessed portion
21b Second recessed portion
22 Substrate region
22a First surface
22b Second surface
22c Third surface
24 Wiring
24a First wiring
24a1 Bonding member
24b Second wiring
24b1 Bonding member
27 Wiring electrode
28 Insulating film
30 Second support body
30a Lower surface
30b First side surface
30c Second side surface
31 Recessed portion
31a Third recessed portion
31b Fourth recessed portion
100, 200 Semiconductor device
110 Substrate
110a Upper surface
110aa Mounting region
110b First side surface
110c Second side surface
110d Lower surface
111 Recessed portion (first recessed portion)
111a Side surface
111b Bottom surface
111c Side surface
112 Recessed portion (second recessed portion)
113 Protruding portion
113a First protruding portion
113b Second protruding portion
114 Wiring
114a First wiring
114b Second wiring
120 Laminate body
120a First resonator surface
120b Second resonator surface
121 Body
130 Dielectric layer
300 Package
400 Semiconductor apparatus

## Claims

1. A manufacturing method for a semiconductor device comprising:
preparing
a laminate body comprising a plurality of semiconductor layers, and
a first support body comprising an upper surface, a side surface, and a recessed portion comprising an opening adjacent to the upper surface and the side surface;
bonding and disposing the laminate body to the upper surface of the first support body;
forming a first end surface at the laminate body; and
forming a first dielectric layer on the first end surface.

2. The manufacturing method for the semiconductor device according to claim 1, wherein
the disposing is subsequent to the forming of the end surface.

3. The manufacturing method for the semiconductor device according to claim 1 or 2, wherein
the laminate body comprises a plurality of laminate bodies,
the recessed portion comprises a plurality of recessed portions, and
the disposing comprises disposing the plurality of laminate bodies corresponding to the plurality of recessed portions of the first support body.

4. The manufacturing method for the semiconductor device according to claim 3, wherein
the plurality of recessed portions comprises a plurality of first recessed portions aligned in a row and a plurality of second recessed portions aligned in a row, and
the disposing comprises disposing each of the plurality of laminate bodies between a respective one of the plurality of first recessed portions and a respective one of the plurality of second recessed portions.

5. The manufacturing method for the semiconductor device according to any one of claims 1 to 4, wherein
the disposing comprises
preparing a second support body, and
disposing the laminate body in a sandwiched manner between the first support body and the second support body.

6. The manufacturing method for the semiconductor device according to claim 5 citing claim 3, wherein
the second support body comprises a plurality of recessed portions, and
the disposing comprises disposing the plurality of laminate bodies corresponding to the plurality of recessed portions of the second support body.

7. The manufacturing method for the semiconductor device according to claim 6, wherein
the plurality of recessed portions of the second support body comprises a plurality of third recessed portions aligned in a line and a plurality of fourth recessed portions aligned in a line, and
the disposing comprises disposing each of the plurality of laminate bodies between a respective one of the plurality of third recessed portions and a respective one of the plurality of fourth recessed portions.

8. The manufacturing method for the semiconductor device according to any one of claims 5 to 7, wherein
the disposing comprises fixing the laminate body to the second support body with a resin layer interposed between the laminate body and the second support body.

9. The manufacturing method for the semiconductor device according to any one of claims 5 to 8, wherein
at least one of the first support body or the second support body comprises a protruding region protruding from a region where the laminate body is disposed, and
the disposing comprises bringing the first support body and the second support body into contact with each other in the protruding region.

10. The manufacturing method for the semiconductor device according to any one of claims 5 to 8, wherein
the disposing comprises positioning the first support body and the second support body in a manner that the first support body and the second support body are in contact with each other.

11. The manufacturing method for the semiconductor device according to any one of claims 5 to 8, wherein
the disposing comprises positioning the first support body and the second support body in a manner that the first support body and the second support body are separated from each other.

12. The manufacturing method for the semiconductor device according to any one of claims 1 to 14, wherein
each of the plurality of semiconductor layers comprises a second end surface, and the forming of the first dielectric layer comprises forming a second dielectric layer on the second end surface.

13. The manufacturing method for the semiconductor device according to any one of claims 1 to 12, wherein
a wiring is routed on an upper surface of the first support body, and
the disposing comprises disposing the laminate body on the wiring.

14. The manufacturing method for the semiconductor device according to any one of claims 1 to 13, wherein
the disposing comprises fixing the laminate body to the first support body with solder interposed between the laminate body and the first support body.

15. The manufacturing method for the semiconductor device according to any one of claims 1 to 14, wherein
the disposing comprises disposing the laminate body in a manner that the first end surface is positioned outside the recessed portion of the first support body.

16. The manufacturing method for the semiconductor device according to any one of claims 1 to 15, wherein
the disposing comprises bonding the laminate body epitaxially laterally grown on a wafer to the first support substrate, and then peeling the laminate body from the wafer.

17. The manufacturing method for the semiconductor device according to claim 16 citing any one of claims 5 to 11, wherein
the disposing comprises disposing the second support body on a surface of the laminate body that is opposed to the wafer.

18. The manufacturing method for the semiconductor device according to any one of claims 4 to 17 citing claim 3, further comprising:
forming a plurality of substrates, each of the plurality of substrates being disposed with a respective one of the plurality of laminate bodies, by dividing the first support body.

19. The manufacturing method for the semiconductor device according to any one of claims 6 to 18 citing claim 5, wherein
the forming of the plurality of substrates comprises dividing only the first support substrate of the first support substrate and the second support substrate.

20. The manufacturing method for the semiconductor device according to any one of claims 6 to 18 citing claim 5, wherein
the forming of the plurality of substrates comprises dividing both the first support substrate and the second support substrate.

21. The manufacturing method for the semiconductor device according to claim 18 citing claim 13, wherein
the wiring comprises a plurality of wirings separated from each other, and
the forming of the plurality of substrates comprises dividing the first support body at an exposed region exposed between the plurality of wirings.

22. The manufacturing method for the semiconductor device according to claim 18 citing claim 13, wherein
the wiring is a continuous wiring, and
the forming of the plurality of substrates comprises dividing both the first support body and the wiring.

23. A semiconductor device comprising:
a substrate comprising an upper surface, a side surface, and a recessed portion comprising an opening adjacent to the upper surface and the side surface;
a laminate body disposed on the upper surface of the substrate, the laminate body comprising a first end surface and a second end surface that are opposed to each other; and
a dielectric layer disposed on the first end surface, wherein
the upper surface comprises a mounting region, the mounting region having a stripe shape, and
the laminate body is positioned on the mounting region.

24. The semiconductor device according to claim 23, wherein
at least one of the first end surface or the second end surface is a cleavage surface.

25. The semiconductor device according to claim 23 or 24, wherein
the dielectric layer is further disposed on the side surface of the substrate.

26. The semiconductor device according to any one of claims 23 to 25, wherein
the dielectric layer is further disposed on a bottom surface of the recessed portion.

27. The semiconductor device according to any one of claims 23 to 26, wherein
the dielectric layer is disposed on a bonding member bonding the laminate body and the substrate.

28. The semiconductor device according to any one of claims 23 to 27, wherein
an area of a bottom surface of the recessed portion is smaller than an area of a side surface of the recessed portion.

29. The semiconductor device according to any one of claims 23 to 28, wherein
the first end surface of the laminate body is an emission surface of light.

30. The semiconductor device according to any one of claims 23 to 29, wherein
the second end surface of the laminate body is a reflection surface of light.

31. The semiconductor device according to any one of claims 23 to 30, wherein
the substrate comprises
a first recessed portion positioned on a side of the first end surface, and
a second recessed portion positioned on a side of the second end surface.

32. The semiconductor device according to claim 31, wherein
the first end surface of the laminate body is positioned on an opening of the first recessed portion.

33. The semiconductor device according to claim 31 or 31, wherein
the second end surface of the laminate body is positioned on an opening of the second recessed portion.

34. The semiconductor device according to any one of claims 31 to 33, wherein
a bottom surface of the second recessed portion is positioned outside an irradiation region of the second end surface.

35. The semiconductor device according to any one of claims 23 to 34, wherein
the laminate body comprises
a body comprising a plurality of semiconductor layers,
a first electrode disposed on an upper surface of the body,
a second electrode disposed on a lower surface of the body, and
a routing wiring configured to route the first electrode to a position below the body.

36. The semiconductor device according to claim 35, wherein
a wiring is disposed on the upper surface of the substrate,
the second electrode is connected to the wiring, and
the first electrode is connected to the wiring through the routing wiring.

37. The semiconductor device according to claim 36, wherein
the substrate comprises a protruding portion protruding outside from the side surface of the recessed portion, and
the wiring is disposed on an upper surface of the protruding portion.

38. The semiconductor device according to any one of claims 23 to 37, wherein
the upper surface of the substrate has an H-shape when viewed in a direction orthogonal to the upper surface.

39. The semiconductor device according to any one of claims 23 to 37, wherein
the upper surface of the substrate has a U-shape when viewed in a direction orthogonal to the upper surface.

40. The semiconductor device according to any one of claims 23 to 39, wherein
the laminate body is a semiconductor laser element.

41. The semiconductor device according to any one of claims 23 to 40, wherein
the laminate body is a GaN-based nitride semiconductor laser element.

42. A semiconductor apparatus comprising:
the semiconductor device according to any one of claims 23 to 41; and
a package mounted with the semiconductor device.

43. The semiconductor apparatus according to claim 42, wherein
the side surface of the substrate of the semiconductor device is bonded to a mounting surface of the package.

44. The semiconductor apparatus according to claim 42 or 43, wherein
the package is a surface mounting type package.

45. The semiconductor apparatus according to any one of claims 42 to 44, wherein
a plurality of the laminate bodies is disposed on the substrate.
